(19) Europäisches Patentamt
European Patent Office
Office européen des brevets

(11) **EP 4 576 058 A1**

(12) **EUROPEAN PATENT APPLICATION**

(43) Date of publication:
**25.06.2025 Bulletin 2025/26**

(21) Application number: **24222201.6**

(22) Date of filing: **20.12.2024**

(51) International Patent Classification (IPC):
**G09G 3/3233** (2016.01)

(52) Cooperative Patent Classification (CPC):
**G09G 3/3233;** G09G 2300/0852; G09G 2300/0861;
G09G 2310/0251

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **21.12.2023 KR 20230189022**

(71) Applicant: **Samsung Display Co., Ltd.
Yongin-si, Gyeonggi-do 17113 (KR)**

(72) Inventors:
• **Yang, Jin-Wook
Yongin-si, Gyeonggi-do (KR)**

• **Park, Sehyuk
Yongin-si, Gyeonggi-do (KR)**
• **Sohn, Youngha
Yongin-si, Gyeonggi-do (KR)**
• **Lee, Donggyu
Yongin-si, Gyeonggi-do (KR)**
• **Jeon, Jae-Hyeon
Yongin-si, Gyeonggi-do (KR)**

(74) Representative: **Gulde & Partner
Patent- und Rechtsanwaltskanzlei mbB
Berliner Freiheit 2
10785 Berlin (DE)**

(54) **PIXEL CIRCUIT, DISPLAY PANEL INCLUDING THE SAME AND DISPLAY APPARATUS INCLUDING THE SAME**

(57) A pixel circuit includes a light emitting element, a first switching element including a control electrode connected to a first node, a first electrode connected to a second node and a second electrode connected to a third node, where the first switching element applies a driving current to the light emitting element, a first capacitor including a first electrode connected to a fourth node and a second electrode connected to the first node, a second switching element which applies a data voltage to the fourth node in response to a data writing gate signal, a third switching element which connects the first node and the third node to each other in response to a path activation gate signal and a fourth switching element which applies a reference voltage to the fourth node in response to the path activation gate signal.

FIG. 2

# EP 4 576 058 A1

**Description**

BACKGROUND

1. Field

Embodiments of the invention relate to a pixel circuit, a display panel including the pixel circuit and a display apparatus including the display panel. More particularly, embodiments of the invention relate to a pixel circuit having sufficient compensation time by separating a data writing period and a compensation period and including fewer transistors, and thus, applicable to a high resolution display apparatus, a display panel including the pixel circuit and a display apparatus including the display panel.

2. Description of the Related Art

Generally, a display apparatus includes a display panel and a display panel driver. The display panel includes a plurality of gate lines, a plurality of data lines, a plurality of emission lines and a plurality of pixels. The display panel driver may include a gate driver, a data driver, an emission driver and a driving controller. The gate driver outputs gate signals to the gate lines. The data driver outputs data voltages to the data lines. The emission driver outputs emission signals to the emission lines. The driving controller controls the gate driver, the data driver and the emission driver.

SUMMARY

In a conventional pixel circuit in which a data writing and a threshold voltage compensation of a driving transistor are simultaneously operated, a compensation time may be limited to one horizontal period such that it would be difficult to apply the pixel circuit to a high resolution display apparatus or a high driving frequency display apparatus. In addition, when a de-multiplexing structure is applied to an output buffer of a data driver, the compensation time may be decreased to a half of one horizontal period such that it would be further difficult to apply the pixel circuit to the high resolution display apparatus or the high driving frequency display apparatus.

In addition, when the number of the transistors of the pixel circuit exceeds a specific number and the number of the capacitors of the pixel circuit exceeds a specific number, it would be difficult to apply the pixel circuit to the high resolution display apparatus due to a limitation in integration.

Embodiments of the invention provide a pixel circuit having sufficient compensation time by separating a data writing period and a compensation period and including fewer transistors, and thus, applicable to a high resolution display apparatus.

Embodiments of the invention also provide a display panel including the pixel circuit.

Embodiments of the invention also provide a display apparatus including the display panel.

In an embodiment of a pixel circuit according to the invention, the pixel circuit includes a light emitting element, a first switching element, a first capacitor, a second switching element, a third switching element and a fourth switching element. In such an embodiment, the first switching element includes a control electrode connected to a first node, a first electrode connected to a second node and a second electrode connected to a third node, where the first switching element applies a driving current to the light emitting element. In such an embodiment, the first capacitor includes a first electrode connected to a fourth node and a second electrode connected to the first node. In such an embodiment, the second switching element applies a data voltage to the fourth node in response to a data writing gate signal. In such an embodiment, the third switching element connects the first node and the third node to each other in response to a path activation gate signal. In such an embodiment, the fourth switching element applies a reference voltage to the fourth node in response to the path activation gate signal.

In an embodiment, the first switching element may be a P-type transistor. In such an embodiment, the second switching element may be an N-type transistor. In such an embodiment, the third switching element may be an N-type transistor. In such an embodiment, the fourth switching element may be an N-type transistor.

In an embodiment, the pixel circuit may further include a fifth switching element which applies a first power voltage to the second node in response to a first emission signal and a sixth switching element which connects the third node and an anode electrode of the light emitting element to each other in response to a second emission signal.

In an embodiment, the pixel circuit may further include a seventh switching element which applies an initialization voltage to the anode electrode of the light emitting element in response to the first emission signal.

In an embodiment, the fifth switching element may be a P-type transistor. In such an embodiment, the seventh switching element may be an N-type transistor.

In an embodiment, the sixth switching element may be a P-type transistor.

In an embodiment, the pixel circuit may further include a seventh switching element which applies an initialization voltage to the anode electrode of the light emitting element in response to a third emission signal.

In an embodiment, the fifth switching element may be a P-type transistor. In such an embodiment, the seventh switching element may be a P-type transistor.

In an embodiment, the pixel circuit may further include an eighth switching element which applies a bias voltage to the second node in response to a bias gate signal.

In an embodiment, the pixel circuit may further include a second capacitor including a first electrode which receives a first power voltage and a second electrode connected to the fourth node.

In an embodiment, the first capacitor may be formed between a first metal layer and a second metal layer disposed on the first metal layer. In such an embodiment, the second capacitor may be formed between the second metal layer and a third metal layer disposed on the second metal layer. In such an embodiment, the first capacitor and the second capacitor may overlap each other.

In an embodiment, the second switching element may include a control electrode which receives the data writing gate signal, a first electrode which receives the data voltage and a second electrode connected to the fourth node. In such an embodiment, the third switching element may include a control electrode which receives the path activation gate signal, a first electrode connected to the first node and a second electrode connected to the third node. In such an embodiment, the fourth switching element may include a control electrode which receives the path activation gate signal, a first electrode connected to the fourth node and a second electrode which receives the reference voltage.

In an embodiment, the pixel circuit may further include a fifth switching element including a control electrode which receives a first emission signal, a first electrode which receives a first power voltage and a second electrode connected to the second node, a sixth switching element including a control electrode which receives a second emission signal, a first electrode connected to the third node and a second electrode connected to an anode electrode of the light emitting element, a seventh switching element including a control electrode which receives the first emission signal, a first electrode which receives an initialization voltage and a second electrode connected to the anode electrode of the light emitting element, an eighth switching element including a control electrode which receives a bias gate signal, a first electrode which receives a bias voltage and a second electrode connected to the second node and a second capacitor including a first electrode which receive the first power voltage and a second electrode connected to the fourth node.

In an embodiment, in an initialization period, the first emission signal may have an inactive level, the second emission signal may have an active level, the path activation gate signal may have an active level, the data writing gate signal may have an inactive level and the bias gate signal may have an inactive level.

In an embodiment, in a compensation period, the first emission signal may have an active level, the second emission signal may have an inactive level, the path activation gate signal may have an active level, the data writing gate signal may have an inactive level and the bias gate signal may have an inactive level.

In an embodiment, in a data writing period, the first emission signal may have an inactive level, the second emission signal may have an inactive level, the path activation gate signal may have an inactive level, the data writing gate signal may have an active level and the bias gate signal may have an inactive level.

In an embodiment, in a bias period, the first emission signal may have an inactive level, the second emission signal may have an inactive level, the path activation gate signal may have an inactive level, the data writing gate signal may have an inactive level and the bias gate signal may have an active level.

In an embodiment, the path activation gate signal may maintain an active level in an initialization period and a compensation period and between the initialization period and the compensation period.

In an embodiment, the path activation gate signal may have an active level in an initialization period and a compensation period. In such an embodiment, the path activation gate signal may have an inactive level between the initialization period and the compensation period.

In an embodiment, the pixel circuit may further include a fifth switching element which applies a first power voltage to the second node in response to a first emission signal and a sixth switching element which connects the third node and an anode electrode of the light emitting element to each other in response to a second emission signal. In such an embodiment, the first emission signal and the second emission signal may be generated from a same signal generator.

In an embodiment, the pixel circuit may further include a fifth switching element which apply a first power voltage to the second node in response to a first emission signal and a sixth switching element which connect the third node and an anode electrode of the light emitting element in response to a second emission signal. In an initialization period, the first emission signal may have an inactive level, the second emission signal may have an active level and the path activation gate signal may have an active level. In a compensation period subsequent to the initialization period, the first emission signal may have an active level, the second emission signal may have an inactive level and the path activation gate signal may have the active level.

In an embodiment of a display panel according to the invention, the display panel includes a first pixel, a second pixel, a third pixel and a fourth pixel sequentially disposed in a first pixel row and a fifth pixel, a sixth pixel, a seventh pixel and an eighth pixel sequentially disposed in a second pixel row. In such an embodiment, at least one selected from the first to eighth pixels includes a light emitting element, a first switching element, a first capacitor, a second switching element, a third switching element and a fourth switching element. In such an embodiment, the first switching element includes a control electrode connected to a first node, a first electrode connected to a second node and a second electrode connected to a third node, where the first switching element applies a driving current to the light emitting element. In such an embodiment, the first capacitor includes a first electrode connected to a fourth node and a second electrode connected to the first node. In such an embodiment, the second switching element applies a data voltage to the fourth node in response to a data writing gate signal. In such an embodiment, the third switching element connects the first node and the third node to each other in response to a path activation gate signal. In such an embodiment, the fourth switching element applies a reference voltage to the fourth node in response to the path activation gate signal.

In an embodiment, the display panel may further include a first data writing gate line connected to the first pixel, the second pixel, the third pixel and the fourth pixel, a second data writing gate line connected to the fifth pixel, the sixth pixel, the seventh pixel and the eighth pixel, a first data line connected to the first pixel and the fifth pixel, a second data line connected to the second pixel and the sixth pixel, a third data line connected to the third pixel and the seventh pixel, a fourth data line connected to the fourth pixel and the eighth pixel, a first switch which activates the first data line in response to a first selection signal, a second switch which activates the second data line in response to the first selection signal, a third switch which activates the third data line in response to a second selection signal and a fourth switch which activates the fourth data line in response to the second selection signal.

In an embodiment, the first data line and the third data line may be connected to each other, and the second data line and the fourth data line may be connected to each other.

In an embodiment, in a first timing, a first data writing gate signal applied to the first data writing gate line may have an active level and the first selection signal may have an active level. In a second timing, the first data writing gate signal may have the active level and the second selection signal may have an active level. In a third timing, a second data writing gate signal applied to the second data writing gate line may have an active level and the first selection signal may have the active level. In a fourth timing, the second data writing gate signal may have the active level and the second selection signal may have the active level.

In an embodiment, the first data line and the second data line may be disposed between the first pixel and the second pixel. In such an embodiment, the third data line and the fourth data line may be disposed between the third pixel and the fourth pixel.

In an embodiment of a display apparatus according to the invention, the display apparatus includes a display panel, a gate driver and a data driver. In such an embodiment, the display panel includes a pixel circuit. In such an embodiment, the gate driver applies a gate signal to a pixel circuit. In such an embodiment, the data driver applies a data voltage to the pixel circuit. In such an embodiment, the pixel circuit includes a light emitting element, a first switching element, a first capacitor, a second switching element, a third switching element and a fourth switching element. In such an embodiment, the first switching element includes a control electrode connected to a first node, a first electrode connected to a second node and a second electrode connected to a third node, where the first switching element applies a driving current to the light emitting element. In such an embodiment, the first capacitor includes a first electrode connected to a fourth node and a second electrode connected to the first node. In such an embodiment, the second switching element applies the data voltage to the fourth node in response to a data writing gate signal. In such an embodiment, the third switching element connects the first node and the third node to each other in response to a path activation gate signal. In such an embodiment, the fourth switching element applies a reference voltage to the fourth node in response to the path activation gate signal.

According to embodiments of the pixel circuit, the display panel including the pixel circuit and the display apparatus including the display panel, the data writing period and the compensation period of the pixel circuit are separated such that the sufficient compensation time of the pixel circuit may be secured.

In such embodiments, The pixel circuit may include the relatively fewer transistors and the relatively fewer capacitors compared to those of the conventional pixel circuit, such that the integration may be enhanced and the pixel circuit may be applicable to a high resolution display apparatus.

According to embodiments of the pixel circuit, the number of integrated circuits which generate the gate signal and the emission signal in the display apparatus is small, such that the dead space may be reduced.

According to embodiments of the pixel circuit, the flip structure of the pixel and the de-multiplexing structure of the data driver may be applicable in the display apparatus such that the power consumption may be reduced and the integration may be enhanced.

According to embodiments of the pixel circuit, the pixel circuit may be driven in a relatively low reference voltage and a relatively low data voltage compared to those of the conventional pixel circuit such that the power consumption may be reduced.

BRIEF DESCRIPTION OF THE DRAWINGS

The above and other features of embodiments of the invention will become more apparent by describing in detailed embodiments thereof with reference to the accompanying drawings, in which:

FIG. 1 is a block diagram illustrating a display apparatus according to an embodiment of the invention;

FIG. 2 is a circuit diagram illustrating a pixel circuit of a display panel of FIG. 1;

FIG. 3 is a timing diagram illustrating input signals applied to the pixel circuit of FIG. 2;

FIG. 4 is a timing diagram illustrating input signals applied to the pixel circuit of FIG. 2;

FIG. 5 is a circuit diagram illustrating an operation of the pixel circuit of FIG. 2 in a first period of FIG. 4;

FIG. 6 is a circuit diagram illustrating an operation of the pixel circuit of FIG. 2 in a second period of FIG. 4;

FIG. 7 is a circuit diagram illustrating an operation of the pixel circuit of FIG. 2 in a third period of FIG. 4;

FIG. 8 is a circuit diagram illustrating an operation of the pixel circuit of FIG. 2 in a fourth period of FIG. 4;

FIG. 9 is a circuit diagram illustrating an operation of the pixel circuit of FIG. 2 in a fifth period of FIG. 4;

FIG. 10 is a circuit diagram illustrating an operation of the pixel circuit of FIG. 2 in a sixth period of FIG. 4;

FIG. 11 is a circuit diagram illustrating an operation of the pixel circuit of FIG. 2 in a seventh period of FIG. 4;

FIG. 12 is a circuit diagram illustrating an operation of the pixel circuit of FIG. 2 in an eighth period of FIG. 4;

FIG. 13 is a circuit diagram illustrating an operation of the pixel circuit of FIG. 2 in a ninth period of FIG. 4;

FIG. 14 is a circuit diagram illustrating an operation of the pixel circuit of FIG. 2 in a tenth period of FIG. 4;

FIG. 15 is a circuit diagram illustrating an operation of the pixel circuit of FIG. 2 in an eleventh period of FIG. 4;

FIG. 16 is a circuit diagram illustrating an operation of the pixel circuit of FIG. 2 in a twelfth period of FIG. 4;

FIG. 17 is a circuit diagram illustrating an operation of the pixel circuit of FIG. 2 in a thirteenth period of FIG. 4;

FIG. 18 is a circuit diagram illustrating an operation of the pixel circuit of FIG. 2 in a fourteenth period of FIG. 4;

FIG. 19 is a circuit diagram illustrating an operation of the pixel circuit of FIG. 2 in a fifteenth period of FIG. 4;

FIG. 20 is a diagram illustrating layer structures of a first capacitor and a second capacitor of FIG. 2;

FIG. 21A is a circuit diagram illustrating a capacitance of a light emitting element of FIG. 2;

FIG. 21B is a diagram illustrating an initialization of an anode electrode of the light emitting element of FIG. 2;

FIG. 22 is a diagram illustrating an initialization voltage according to a pixel of the display panel of FIG. 1;

FIG. 23 is a circuit diagram illustrating a de-multiplexing structure of a data driver of FIG. 1;

FIG. 24A is a timing diagram illustrating input signals for operating a de-multiplexing structure of a data driver according to a comparative embodiment;

FIG. 24B is a timing diagram illustrating input signals for operating the de-multiplexing structure of the data driver of FIG. 23 according to an embodiment of the invention;

FIGS. 25A to 25D are diagrams illustrating a driving method of a flip structure of the pixel of the display panel of FIG. 1 and the de-multiplexing structure of the data driver of FIG. 1;

FIG. 26A is a diagram illustrating a data voltage of a first pixel group and a voltage of a fourth node in FIGS. 25A to 25D;

FIG. 26B is a diagram illustrating a data voltage of a second pixel group and the voltage of the fourth node in FIGS. 25A to 25D;

FIG. 27 is a table illustrating examples of voltages of the fourth node and voltages of a first node of the pixel circuit of FIG. 2;

FIG. 28 is a timing diagram illustrating input signals applied to a pixel circuit of a display panel of a display apparatus according to an embodiment of the invention;

FIG. 29 is a circuit diagram illustrating a pixel circuit of a display panel of a display apparatus according to an embodiment of the invention;

FIG. 30 is a timing diagram illustrating input signals applied to the pixel circuit of FIG. 29;

FIG. 31 is a block diagram illustrating an electronic apparatus according to an embodiment of the invention; and

FIG. 32 is a diagram illustrating an example in which the electronic apparatus of FIG. 31 is implemented as a smart phone.

DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Hereinafter, embodiments of the invention will be described in detail with reference to the accompanying drawings.

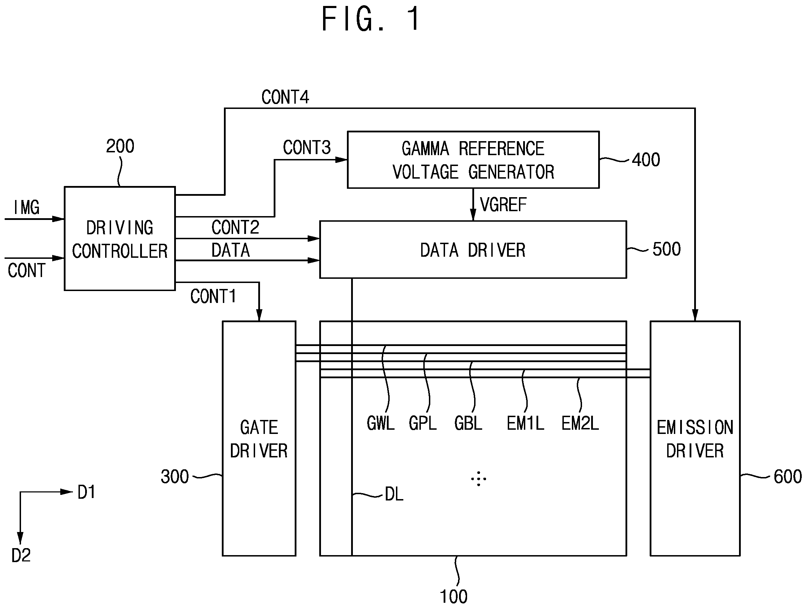

FIG. 1 is a block diagram illustrating a display apparatus according to an embodiment of the invention.

Referring to FIG. 1, an embodiment of the display apparatus includes a display panel 100 and a display panel driver. The display panel driver includes a driving controller 200, a gate driver 300, a gamma reference voltage generator 400, a data driver 500 and an emission driver 600.

The display panel 100 has a display region on which an image is displayed and a peripheral region adjacent to the display region.

The display panel 100 includes a plurality of gate lines GWL, GPL and GBL, a plurality of data lines DL, a plurality of emission lines EM1L and EM2L and a plurality of pixels electrically connected to the gate lines GWL, GPL and GBL, the data lines DL and the emission lines EM1L and EM2L. The gate lines GWL, GPL and GBL may extend in a first direction D1, the data lines DL may extend in a second direction D2 crossing the first direction D1 and the emission lines EM1L and EM2L may extend in the first direction D1.

The driving controller 200 receives input image data IMG and an input control signal CONT from an external apparatus. In an embodiment, for example, the input image data IMG may include red image data, green image data and blue image data. The input image data IMG may include white image data. In another embodiment, for example, the input image data IMG may include magenta image data, cyan image data and yellow image data. The input control signal CONT may include a master clock signal and a data enable signal. The input control signal CONT may further include a vertical synchronizing signal and a horizontal synchronizing signal.

The driving controller 200 generates a first control signal CONT1, a second control signal CONT2, a third control signal CONT3, a fourth control signal CONT4 and a data signal DATA based on the input image data IMG and the input control signal CONT.

The driving controller 200 generates the first control signal CONT1 for controlling an operation of the gate driver 300 based on the input control signal CONT, and outputs the first control signal CONT1 to the gate driver 300. The first control signal CONT1 may include a vertical start signal and a gate clock signal.

The driving controller 200 generates the second control signal CONT2 for controlling an operation of the data driver 500 based on the input control signal CONT, and outputs the second control signal CONT2 to the data driver 500. The second control signal CONT2 may include a horizontal start signal and a load signal.

The driving controller 200 generates the data signal DATA based on the input image data IMG The driving controller 200 outputs the data signal DATA to the data driver 500.

The driving controller 200 generates the third control signal CONT3 for controlling an operation of the gamma reference voltage generator 400 based on the input control signal CONT, and outputs the third control signal CONT3 to the gamma reference voltage generator 400.

The driving controller 200 generates the fourth control signal CONT4 for controlling an operation of the emission driver 600 based on the input control signal CONT, and outputs the fourth control signal CONT4 to the emission driver 600.

The gate driver 300 generates gate signals driving the gate lines GWL, GPL and GBL in response to the first control signal CONT1 received from the driving controller 200. The gate driver 300 may output the gate signals to the gate lines GWL, GPL and GBL. The gate signals may include a data writing gate signal, a path activation gate signal and a bias gate signal.

In an embodiment of the invention, the gate driver 300 may be integrated on the peripheral region of the display panel 100. In an embodiment of the invention, the gate driver 300 may be mounted on the peripheral region of the display panel 100.

The gamma reference voltage generator 400 generates a gamma reference voltage VGREF in response to the third control signal CONT3 received from the driving controller 200. The gamma reference voltage generator 400 provides the gamma reference voltage VGREF to the data driver 500. The gamma reference voltage VGREF has a value (or a voltage level) corresponding to a value (or level) of the data signal DATA.

In an embodiment, the gamma reference voltage generator 400 may be disposed in the driving controller 200, or in the data driver 500.

The data driver 500 receives the second control signal CONT2 and the data signal DATA from the driving controller 200, and receives the gamma reference voltages VGREF from the gamma reference voltage generator 400. The data driver 500 converts the data signal DATA into data voltages having an analog type using the gamma reference voltages VGREF. The data driver 500 outputs the data voltages to the data lines DL.

In an embodiment of the invention, the data driver 500 may be integrated on the peripheral region of the display panel 100. In an embodiment of the invention, the data driver 500 may be mounted on the peripheral region of the display panel 100.

The emission driver 600 generates emission signals to drive the emission lines EM1L and EM2L in response to the fourth control signal CONT4 received from the driving controller 200. The emission driver 600 may output the emission signals to the emission lines EM1L and EM2L.

In an embodiment of the invention, the emission driver 600 may be integrated on the peripheral region of the display panel 100. In an embodiment of the invention, the emission driver 600 may be mounted on the peripheral region of the display panel 100.

Although an embodiment where the gate driver 300 is disposed at a first side of the display panel 100 and the emission driver 600 is disposed at a second side of the display panel 100 opposite to the first side is shown in FIG. 1 for convenience of illustration and description, the invention may not be limited thereto. In another embodiment, for example, both of the gate driver 300 and the emission driver 600 may be disposed at the first side of the display panel 100. In another embodiment, for example, the gate driver 300 and the emission driver 600 may be integrally formed as a single module or chip. In another embodiment, for example, both of the gate driver 300 and the emission driver 600 may be disposed at both sides of the display panel 100.

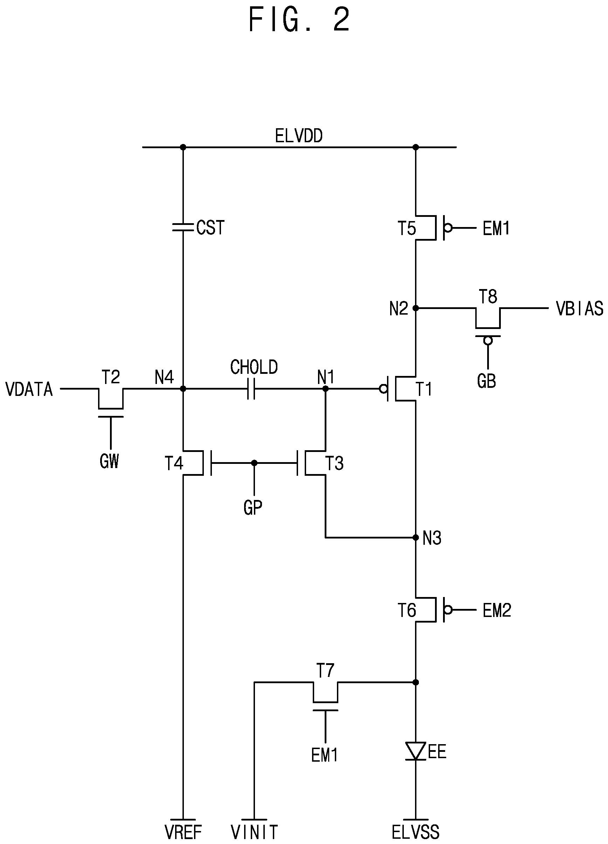

FIG. 2 is a circuit diagram illustrating a pixel circuit of the display panel 100 of FIG. 1.

Referring to FIGS. 1 and 2, an embodiment of the pixel circuit includes a light emitting element EE, a first switching element T1, a first capacitor CHOLD, a second switching element T2, a third switching element T3 and a fourth switching element T4.

The first switching element T1 may include a control electrode connected to a first node N1, a first electrode connected to a second node N2 and a second electrode connected to a third node N3. The first switching element T1 may apply a driving current to the light emitting element EE.

The first capacitor CHOLD may include a first electrode connected to a fourth node N4 and a second electrode connected to the first node N1.

The second switching element T2 may apply a data voltage VDATA to the fourth node N4 in response to the data writing gate signal GW. The second switching element T2 may include a control electrode that receives the data writing gate signal GW, a first electrode that receives the data voltage VDATA and a second electrode connected to the fourth node N4.

The third switching element T3 may connect the first node N1 and the third node N3 to each other in response to the path activation gate signal GP. The third switching element T3 may include a control electrode that receives the path activation gate signal GP, a first electrode connected to the first node N1 and a second electrode connected to the third node N3.

The fourth switching element T4 may apply a reference voltage VREF to the fourth node N4 in response to the path activation gate signal GP. The fourth switching element T4 may include a control electrode that receives the path activation gate signal GP, a first electrode connected to the fourth node N4 and a second electrode that receives the reference voltage VREF.

In an embodiment, as shown in FIG. 2, the pixel circuit may further include a fifth switching element T5 and a sixth switching element T6.

The fifth switching element T5 may apply a first power voltage ELVDD to the second node N2 in response to a first emission signal EM1. The fifth switching element T5 may include a control electrode that receives the first emission signal EM1, a first electrode that receives the first power voltage ELVDD and a second electrode connected to the second node N2.

The sixth switching element T6 may connect the third node N3 and an anode electrode of the light emitting element EE to each other in response to a second emission signal EM2. The sixth switching element T6 may include a control electrode that receives the second emission signal EM2, a first electrode connected to the third node N3 and a second electrode connected to the anode electrode of the light emitting element EE.

In an embodiment, as shown in FIG. 2, the pixel circuit may further include a seventh switching element T7. The seventh switching element T7 may apply an initialization voltage VINIT to the anode electrode of the light emitting element EE in response to the first emission signal EM1. The seventh switching element T7 may include a control electrode that receives the first emission signal EM1, a first electrode that receives the initialization voltage VINIT and a second electrode connected to the anode electrode of the light emitting element EE.

In an embodiment, as shown in FIG. 2, the pixel circuit may further include an eighth switching element T8. The eighth switching element T8 may apply a bias voltage VBIAS to the second node N2 in response to the bias gate signal GB. The eighth switching element T8 may include a control electrode that receives the bias gate signal GB, a first electrode that receives the bias voltage VBIAS and a second electrode connected to the second node N2.

In an embodiment, as shown in FIG. 2, the pixel circuit may further include a second capacitor CST including a first electrode that receives the first power voltage ELVDD and a second electrode connected to the fourth node N4.

A second power voltage ELVSS may be applied to a cathode electrode of the light emitting element EE.

In an embodiment, for example, the first power voltage ELVDD is a high power voltage for emitting the light emitting element EE and the second power voltage ELVSS is a low power voltage for emitting the light emitting element EE. The first power voltage ELVDD may be greater than the second power voltage ELVSS.

Each of the first to eighth switching elements T1 to T8 may include a single transistor. However, the invention may not be limited thereto. Alternatively, each of the first to eighth switching elements T1 to T8 may include plural transistors connected to each other in series.

In an embodiment, some of the transistors in the pixel circuit may be P-type transistors and some of the transistors in the pixel circuit may be N-type transistors. In an embodiment, for example, the P-type transistor may be a low temperature polycrystalline silicon (LTPS) transistor. In an embodiment, for example, the N-type transistor may be an oxide semiconductor transistor.

For example, the first switching element T1 may be the P-type transistor. The second switching element T2 may be the N-type transistor. The third switching element T3 may be the N-type transistor. The fourth switching element T4 may be the N-type transistor.

For example, the fifth switching element T5 may be the P-type transistor. The sixth switching element T6 may be the P-type transistor. The seventh switching element T7 may be the N-type transistor. The eighth switching element T8 may be the P-type transistor.

The fifth switching element T5 is the P-type transistor, the seventh switching element T7 is the N-type transistor, and the same signal (the first emission signal EM1) is applied to the control electrode of the fifth switching element T5 and the control electrode of the seventh switching element T7. Thus, when the fifth switching element T5 is turned on, the seventh switching element T7 may be turned off, and when the fifth switching element T5 is turned off, the seventh switching element T7 may be turned on. For convenience of description, a low level of the first emission signal EM1 is defined as an active level of the first emission signal EM1 based on the fifth switching element T5. Alternatively, a high level of the first emission signal EM1 may be defined as the active level of the first emission signal EM1 based on the seventh switching element T7.

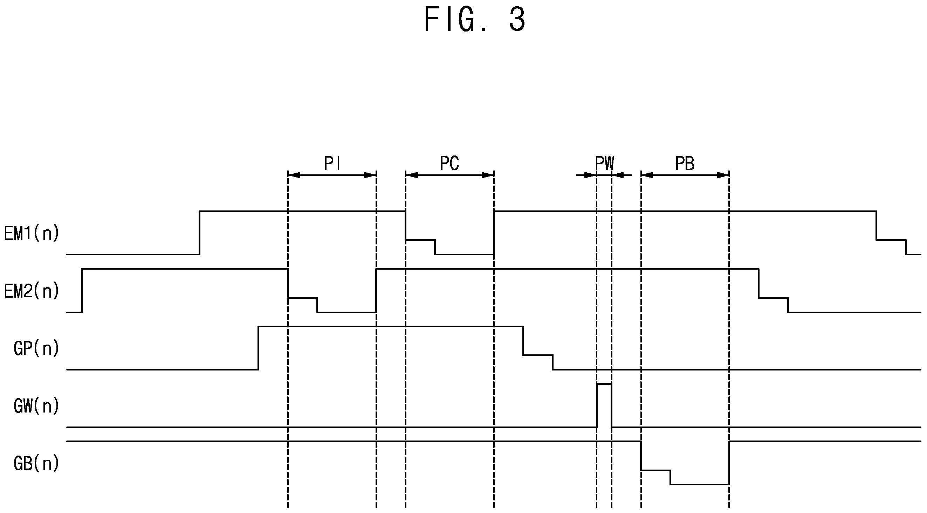

FIG. 3 is a timing diagram illustrating input signals applied to the pixel circuit of FIG. 2.

Referring to FIGS. 1 to 3, a driving timing of the pixel circuit may include an initialization period PI, a compensation period PC, a data writing period PW and a bias period PB during one frame period.

For example, in the initialization period PI, the first emission signal EM1 may have an inactive level, the second emission signal EM2 may have an active level, the path activation gate signal GP may have an active level, the data writing gate signal GW may have an inactive level and the bias gate signal GB may have an inactive level.

For example, in the compensation period PC, the first emission signal EM1 may have an active level, the second emission signal EM2 may have an inactive level, the path activation gate signal GP may have the active level, the data writing gate signal GW may have the inactive level and the bias gate signal GB may have the inactive level.

For example, in the data writing period PW, the first emission signal EM1 may have the inactive level, the second emission signal EM2 may have the inactive level, the path activation gate signal GP may have an inactive level, the data writing gate signal GW may have an active level and the bias gate signal GB may have the inactive level.

For example, in the bias period PB, the first emission signal EM1 may have the inactive level, the second emission signal EM2 may have the inactive level, the path activation gate signal GP may have the inactive level, the data writing gate signal GW may have the inactive level and the bias gate signal GB may have an active level.

In an embodiment, the path activation gate signal GP may maintain the active level in the initialization period PI and the compensation period PC and between the initialization period PI and the compensation period PC.

In an embodiment, where the transistor that receives the first emission signal EM1 and the second emission signal EM2, the path activation gate signal GP, the data writing gate signal GW and the bias gate signal GB is a P-type transistor, the active level may be a low level and the inactive level may be a high level. In another embodiment, where the transistor that receives the first emission signal EM1 and the second emission signal EM2, the path activation gate signal GP, the data writing gate signal GW and the bias gate signal GB is an N-type transistor, the active level may be a high level and the inactive level may be a low level.

In FIG. 3, "(n)" means an n-th pixel row. The pixel circuit of FIG. 2 that receives the first emission signal EM1(n) and the second emission signal EM2(n), the path activation gate signal GP(n), the data writing gate signal GW(n) and the bias gate signal GB(n) may be included in the n-th pixel row. In the disclosure, "(n)" may be omitted.

In an embodiment, for example, the first emission signal EM1 and the second emission signal EM2 may be generated from a same signal generator. In an embodiment, for example, a timing of the first emission signal EM1 and a timing of the second emission signal EM2 may be different from each other but a waveform of the first emission signal EM1 and a waveform of the second emission signal EM2 may be the same as each other. As shown in FIG. 3, when the waveform of the second emission signal EM2 is shifted, the waveform of the second emission signal EM2 may overlap the waveform of the first emission signal EM1.

In an embodiment, the first emission signal EM1 and the second emission signal EM2 are generated from the same signal generator such that the number of integrated circuits may be reduced and accordingly, a dead space of the display apparatus may be reduced.

In the initialization period PI, the first emission signal EM1 may have the inactive level, the second emission signal EM2 may have the active level and the path activation gate signal GP may have the active level. In the compensation period PC subsequent to the initialization period PI, the first emission signal EM1 may have the active level, the second emission signal EM2 may have the inactive level and the path activation gate signal GP may have the active level.

In the initialization period PI, the fourth node N4 may be initialized to the reference voltage VREF and the first node N1 may be initialized to the initialization voltage VINIT in response to the first emission signal EM1 having the inactive level, the second emission signal EM2 having the active level and the path activation gate level having the active level.

In the compensation period PC, a threshold voltage of the first switching element T1 may be compensated using the first power voltage ELVDD in response to the first emission signal EM1 having the active level, the second emission signal EM2 having the inactive level and the path activation gate level having the active level.

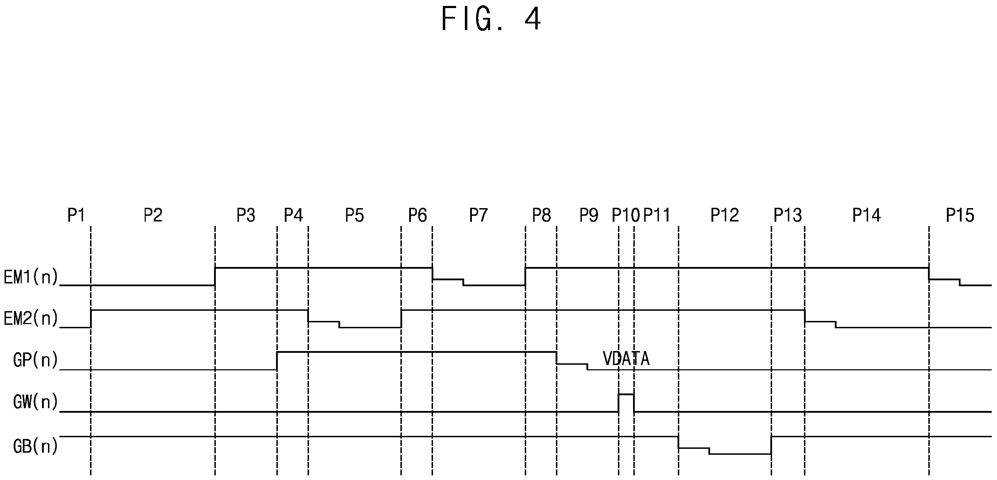

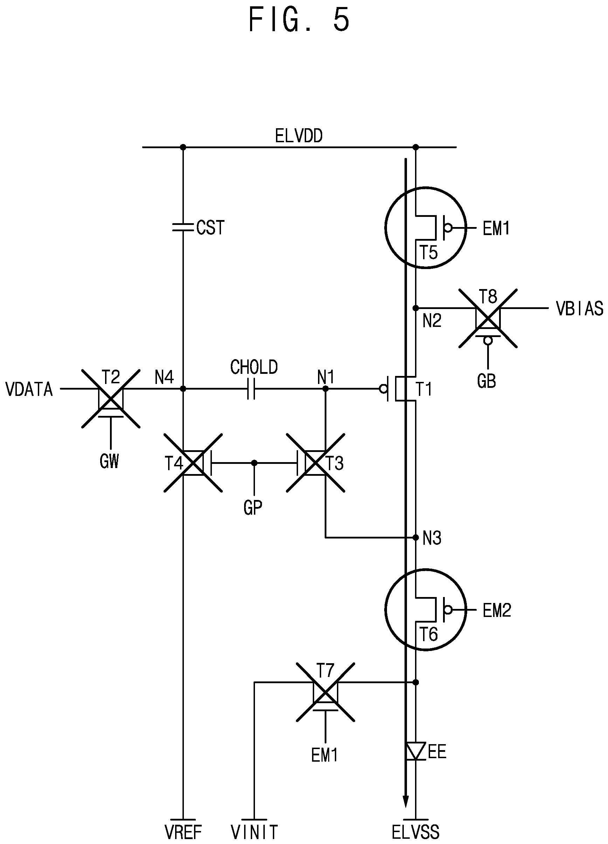

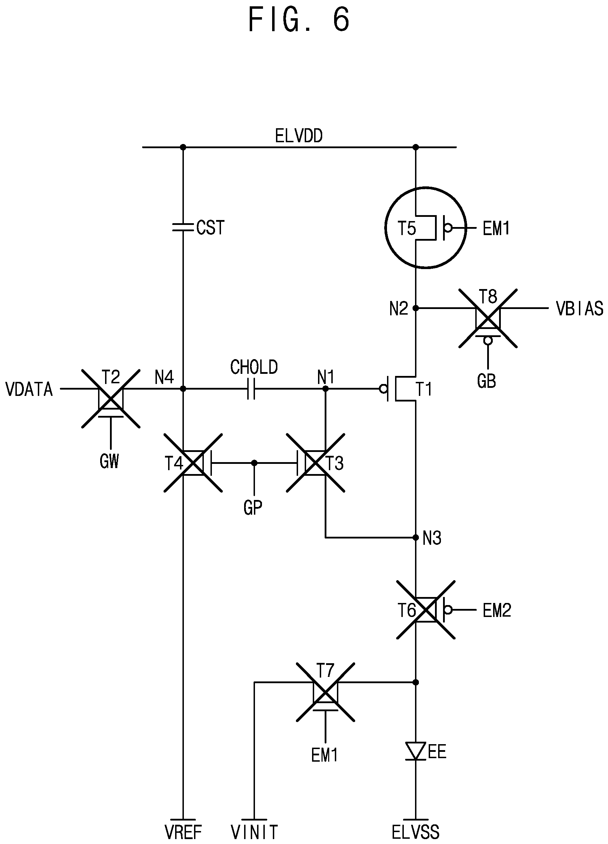

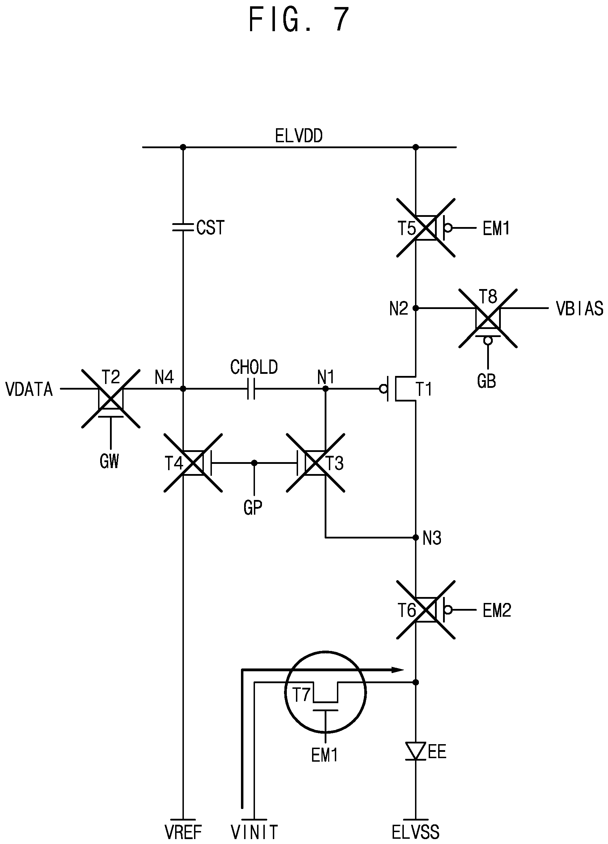

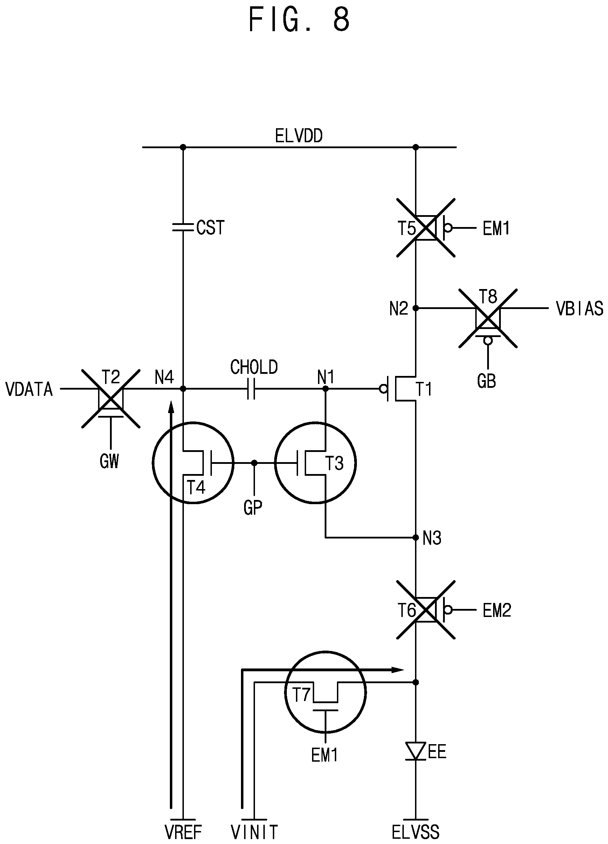

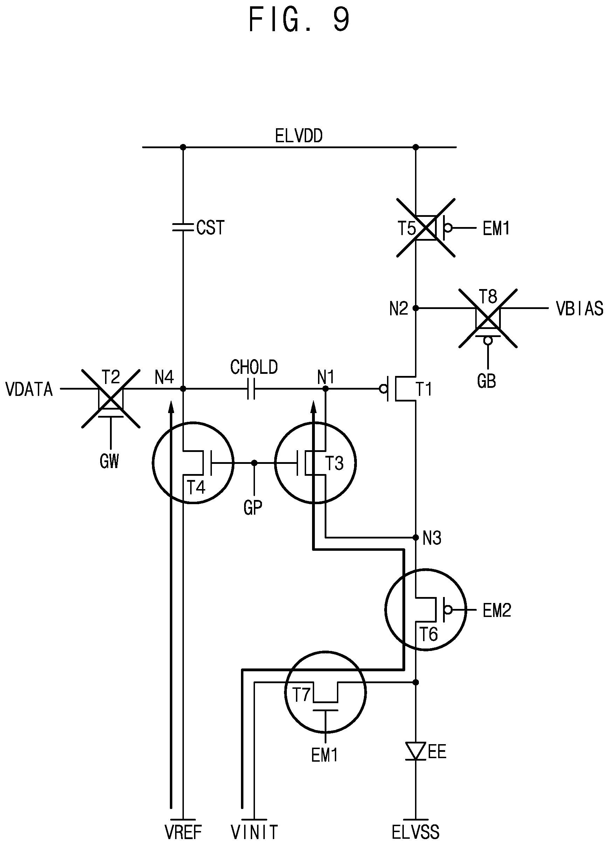

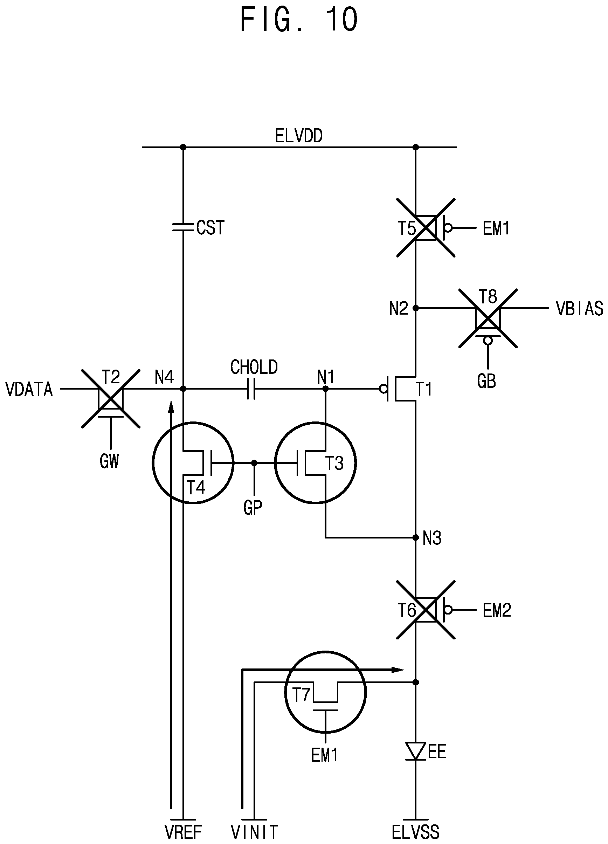

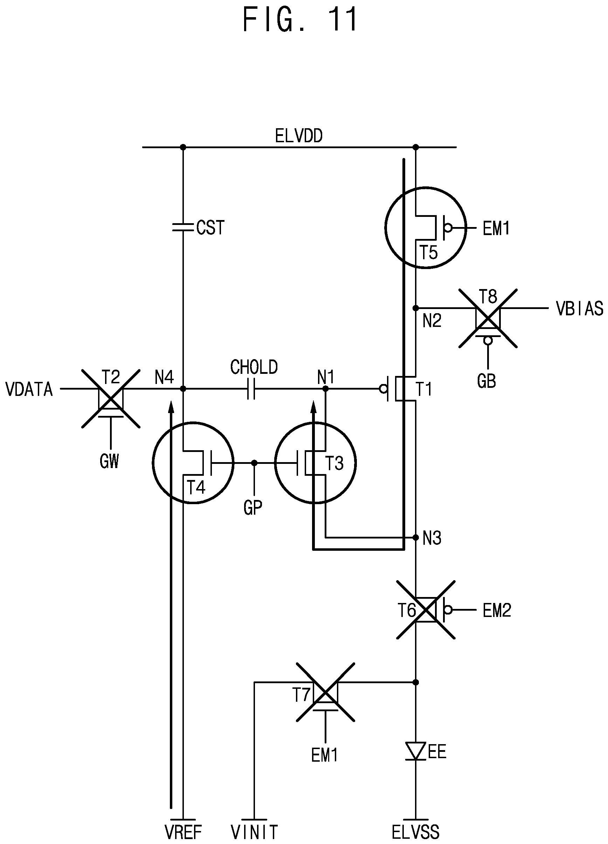

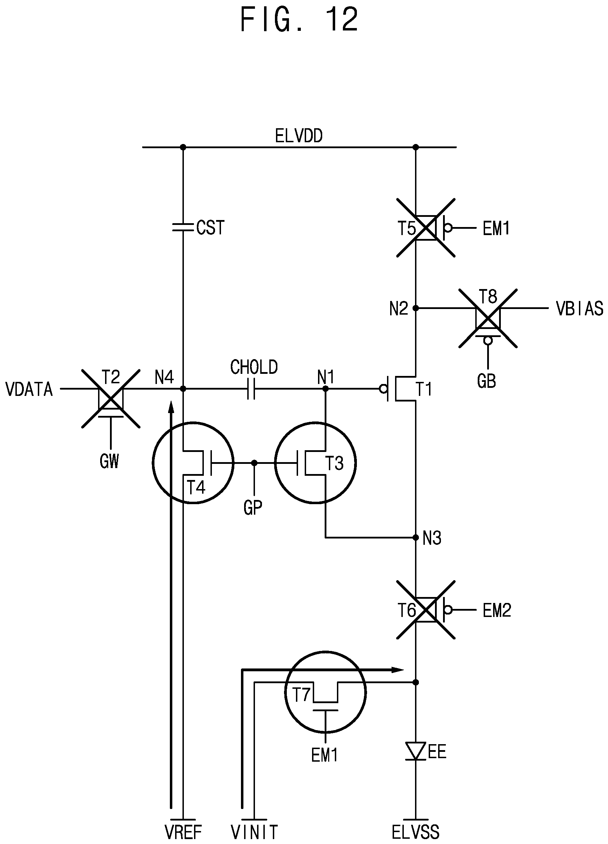

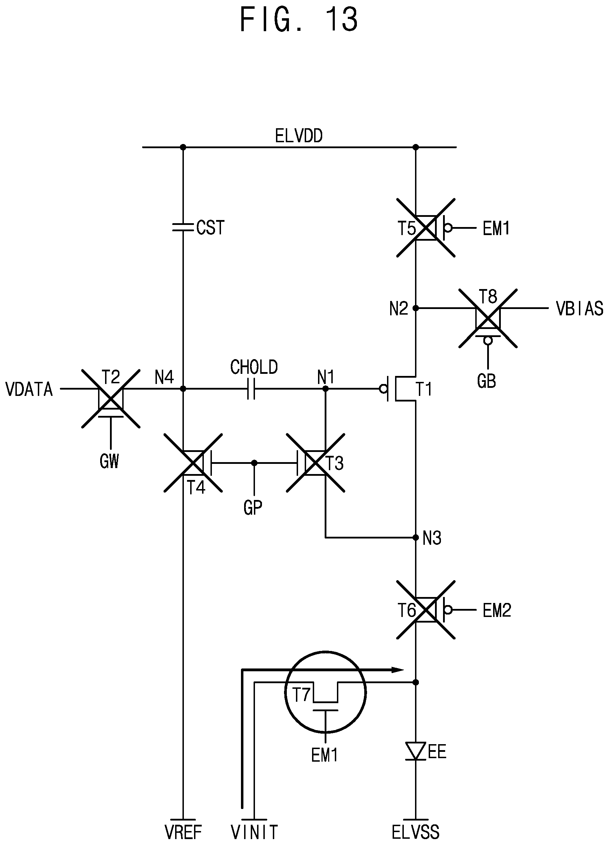

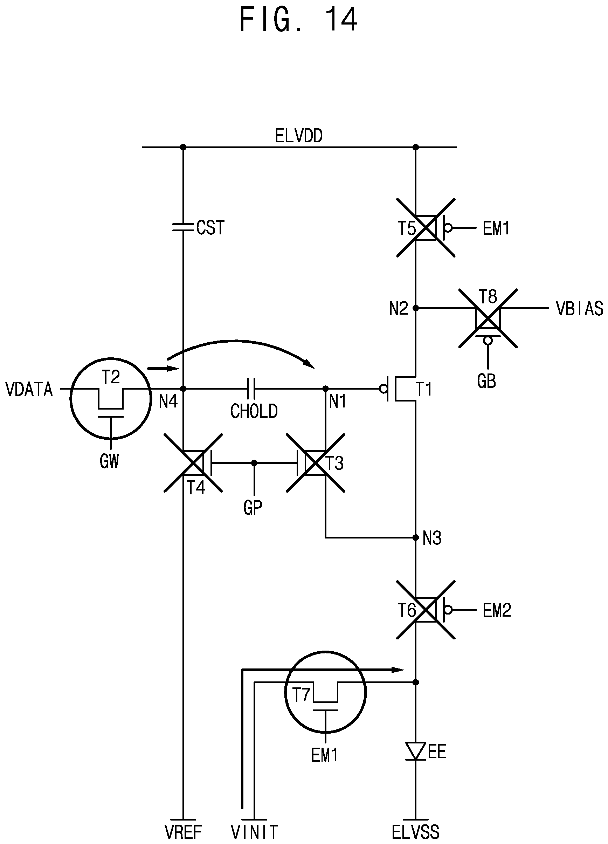

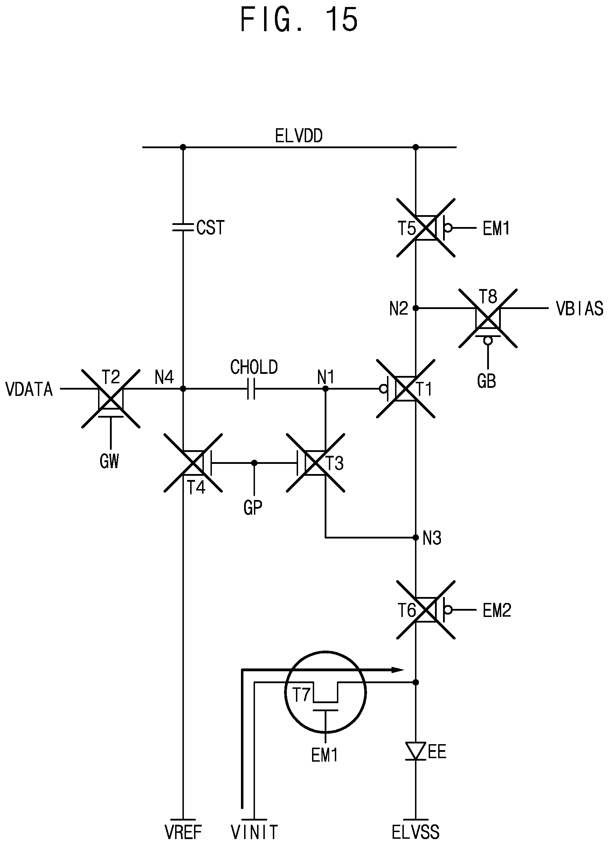

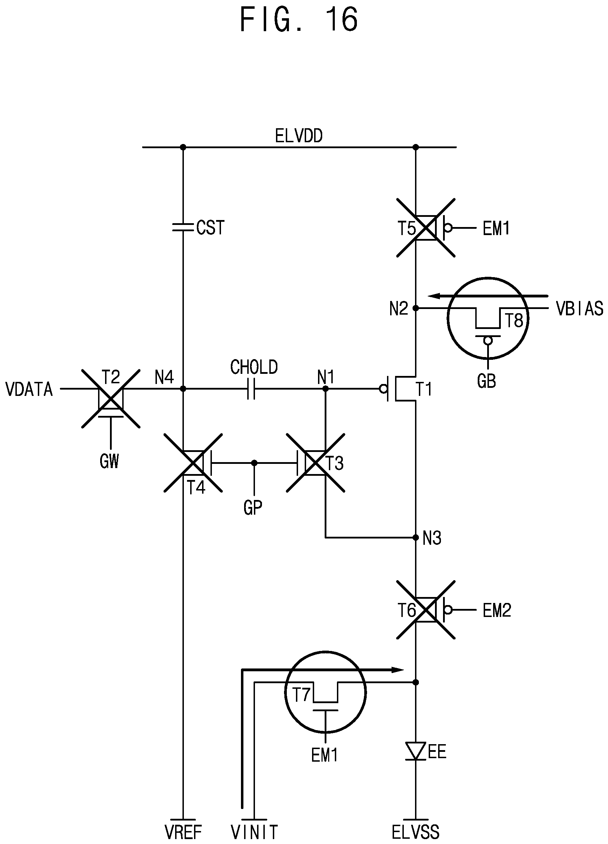

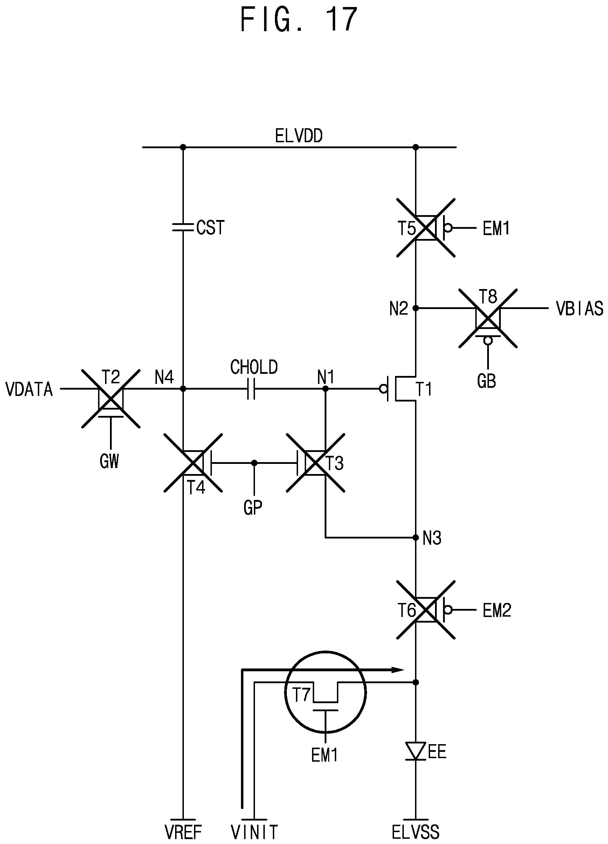

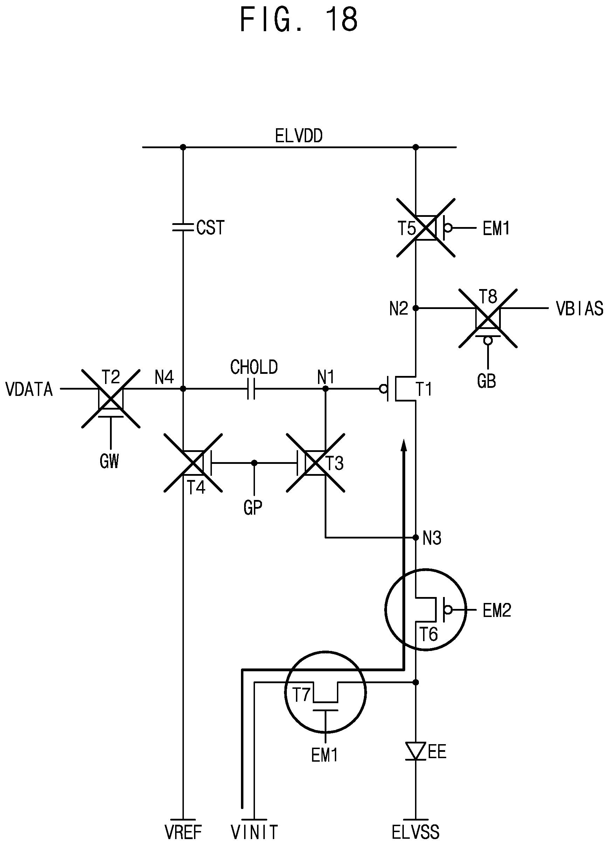

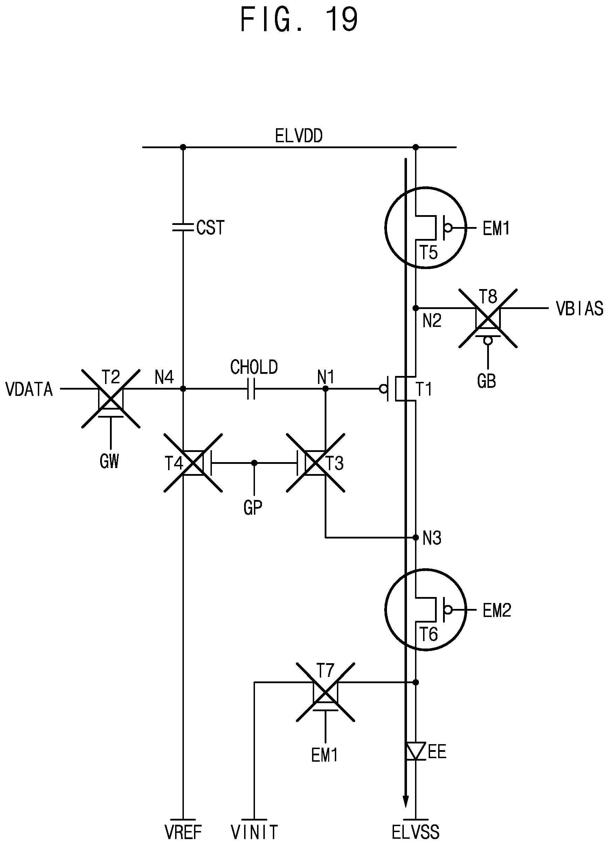

FIG. 4 is a timing diagram illustrating input signals applied to the pixel circuit of FIG. 2. FIG. 5 is a circuit diagram illustrating an operation of the pixel circuit of FIG. 2 in a first period P1 of FIG. 4. FIG. 6 is a circuit diagram illustrating an operation of the pixel circuit of FIG. 2 in a second period P2 of FIG. 4. FIG. 7 is a circuit diagram illustrating an operation of the pixel circuit of FIG. 2 in a third period P3 of FIG. 4. FIG. 8 is a circuit diagram illustrating an operation of the pixel circuit of FIG. 2 in a fourth period P4 of FIG. 4. FIG. 9 is a circuit diagram illustrating an operation of the pixel circuit of FIG. 2 in a fifth period P5 of FIG. 4. FIG. 10 is a circuit diagram illustrating an operation of the pixel circuit of FIG. 2 in a sixth period P6 of FIG. 4. FIG. 11 is a circuit diagram illustrating an operation of the pixel circuit of FIG. 2 in a seventh period P7 of FIG. 4. FIG. 12 is a circuit diagram illustrating an operation of the pixel circuit of FIG. 2 in an eighth period P8 of FIG. 4. FIG. 13 is a circuit diagram illustrating an operation of the pixel circuit of FIG. 2 in a ninth period P9 of FIG. 4. FIG. 14 is a circuit diagram illustrating an operation of the pixel circuit of FIG. 2 in a tenth period P10 of FIG. 4. FIG. 15 is a circuit diagram illustrating an operation of the pixel circuit of FIG. 2 in an eleventh period P11 of FIG. 4. FIG. 16 is a circuit diagram illustrating an operation of the pixel circuit of FIG. 2 in a twelfth period P12 of FIG. 4. FIG. 17 is a circuit diagram illustrating an operation of the pixel circuit of FIG. 2 in a thirteenth period P13 of FIG. 4. FIG. 18 is a circuit diagram illustrating an operation of the pixel circuit of FIG. 2 in a fourteenth period P14 of FIG. 4. FIG. 19 is a circuit diagram illustrating an operation of the pixel circuit of FIG. 2 in a fifteenth period P15 of FIG. 4.

Hereinafter, operations of the pixel circuit in first to fifteenth periods P1 to P15 will be described in detail.

The fifth period P5 of FIG. 4 may be the initialization period PI of FIG. 3, the seventh period P7 of FIG. 4 may be the compensation period PC of FIG. 3, the tenth period P10 of FIG. 4 may be the data writing period PW of FIG. 3 and the twelfth period P12 of FIG. 4 may be the bias period PB.

Referring to FIGS. 4 and 5, the first period P1 may be the light emission period. In the first period P1, the fifth switching element T5 may be turned on in response to the first emission signal EM1 and the sixth switching element T6 may be turned on in response to the second emission signal EM2.

In the first period P1, the driving current may flow through the light emitting element EE along a path of the fifth switching element T5, the first switching element T1 and the sixth switching element T6. In the first period P1, the light emitting element EE may emit a light by the driving current. A degree of turning-on of the first switching element T1 may be determined by the data voltage VDATA.

Referring to FIGS. 4 and 6, a second period P2 subsequent to the first period P1 may be a first light emitting off period.

In the second period P2, the second emission signal EM2 is changed from a low level to a high level such that the sixth switching element T6 may be turned off. In the second period P2, the sixth switching element T6 is turned off such that the light emitting element EE stops emitting a light.

Referring to FIGS. 4 and 7, a third period P3 subsequent to the second period P2 may be a second light emitting off period.

In the third period P3, the first emission signal EM1 is changed from a low level to a high level such that the fifth switching element T5 may be turned off.

In the third period P3, the first emission signal EM1 is changed from the low level to the high level such that the seventh switching element T7 may be turned on. In the third period P3, the seventh switching element T7 is turned on such that the initialization voltage VINIT may be applied to the anode electrode of the light emitting element EE.

Referring to FIGS. 4 and 8, a fourth period P4 subsequent to the third period P3 may be a path activation period prior to initialization.

In the fourth period P4, the path activation gate signal GP is changed from a low level to a high level such that the third switching element T3 and the fourth switching element T4 may be turned on. In the fourth period P4, the fourth switching element T4 is turned on such that the reference voltage VREF may be applied to the fourth node N4.

Referring to FIGS. 4 and 9, a fifth period P5 subsequent to the fourth period P4 may be the initialization period PI.

In the fifth period P5, the second emission signal EM2 is changed from the high level to the low level, the sixth switching element T6 may be turned on. In the fifth period P5, the reference voltage VREF may be applied to the fourth node N4 through the fourth switching element T4 and the initialization voltage VINIT may be applied to the first node N1 along a path of the seventh switching element T7, the sixth switching element T6 and the third switching element T3.

Referring to FIGS. 4 and 10, a sixth period P6 subsequent to the fifth period P5 may be a initialization termination period.

In the sixth period P6, the second emission signal EM2 is changed from the low level to the high level, the sixth switching element T6 may be turned off. In the sixth period P6, the sixth switching element T6 is turned off such that the initialization voltage VINIT may not be applied to the first node N1.

Referring to FIGS. 4 and 11, a seventh period P7 subsequent to the sixth period P6 may be the compensation period PC.

In the seventh period P7, the first emission signal EM1 is changed from the high level to the low level such that the fifth switching element T5 may be turned on. In the seventh period P7, the reference voltage VREF may be applied to the fourth node N4 through the fourth switching element T4 and the first power voltage ELVDD may be applied to the first node N1 along a path of the fifth switching element T5, the first switching element T1 and the third switching element T3. In the seventh period P7, the first power voltage ELVDD may be a compensation voltage source for compensating a threshold voltage of the first switching element T1. In the seventh period P7, the voltage of the fourth node N4 may be the reference voltage VREF and the voltage of the first node N1 may be ELVDD-VTH. Herein, VTH denotes the threshold voltage of the first switching element T1.

Referring to FIGS. 4 and 12, an eighth period P8 subsequent to the seventh period P7 may be a compensation termination period.

In the eighth period P8, the first emission signal EM1 is changed from the low level to the high level such that the fifth switching element T5 may be turned off. In the eighth period P8, the fifth switching element T5 is turned off such that the first power voltage ELVDD may not be applied to the first node N1.

In the eighth period P8, the first emission signal EM1 is changed from the low level to the high level such that the seventh switching element T7 may be turned on. In the eighth period P8, the seventh switching element T7 is turned on such that the initialization voltage VINIT may be applied to the anode electrode of the light emitting element EE.

Referring to FIGS. 4 and 13, a ninth period P9 subsequent to the eighth period P8 may be a path activation period prior to data writing.

In the ninth period P9, the path activation gate signal GP is changed from the high level to the low level such that the third switching element T3 and the fourth switching element T4 may be turned off. In the ninth period P9, the fourth switching element T4 is turned off such that the reference voltage VREF may not be applied to the fourth node N4.

Referring to FIGS. 4 and 14, a tenth period P10 subsequent to the ninth period P9 may be the data writing period PW.

In the tenth period P10, the data writing gate signal GW is changed from a low level to a high level such that the second switching element T2 may be turned on. In the tenth period P10, the second switching element T2 is turned on such that the data voltage VDATA may be applied to the fourth node N4 through the second switching element T2. In the tenth period P10, the data voltage VDATA is applied to the fourth node N4 such that the voltage of the first node N1 may be changed by a coupling of the first capacitor CHOLD. In the tenth period P10, the voltage of the fourth node N4 may be the data voltage VDATA and the voltage of the first node N1 may be ELVDD- VTH+VDATA- VREF.

Referring to FIGS. 4 and 15, an eleventh period P11 subsequent to the tenth period P10 may be a data writing termination period.

In the eleventh period P11, the data writing gate signal GW is changed from the high level to the low level such that the second switching element T2 may be turned off. In the eleventh period P11, the second switching element T2 is turned off such that the data voltage VDATA may not be applied to the fourth node N4.

Referring to FIGS. 4 and 16, a twelfth period P12 subsequent to the eleventh period P11 may be the bias period PB.

In the twelfth period P12, the bias gate signal GB is changed from a high level to a low level such that the eighth switching element T8 may be turned on. In the twelfth period P12, the eighth switching element T8 is turned on such that the bias voltage VBIAS may be applied to the second node N2 through the eighth switching element T8.

Referring to FIGS. 4 and 17, a thirteenth period P13 subsequent to the twelfth period P12 may be a bias termination period.

In the thirteenth period P13, the bias gate signal GB is changed from the low level to the high level such that the eighth switching element T8 may be turned off. In the thirteenth period P13, the eighth switching element T8 is turned off such that the bias voltage VBIAS may not be applied to the second node N2.

Referring to FIGS. 4 and 18, a fourteenth period P14 subsequent to the thirteenth period P13 may be a first light emitting on period.

In the fourteenth period P14, the second emission signal EM2 is changed from the high level to the low level such that the sixth switching element T6 may be turned on. In the fourteenth period P14, the sixth switching element T6 is turned on such that the initialization voltage VINIT may be applied to the third node N3 along a path of the seventh switching element T7 and the sixth switching element T6. In the fourteenth period P14, a drain electrode N3 of the first switching element T1 may be initialized.

Referring to FIGS. 4 and 19, a fifteenth period P15 subsequent to the fourteenth period P14 may be a second light emitting on period.

In the fifteenth period P15, the first emission signal EM1 is changed from the high level to the low level such that the fifth switching element T5 may be turned on.

In the fifteenth period P15, the fifth switching element T5 may be turned on in response to the first emission signal EM1 and the sixth switching element T6 may be turned on in response to the second emission signal EM2.

In the fifteenth period P15, the driving current may be flow through the light emitting element EE along a path of the fifth switching element T5, the first switching element T1 and the sixth switching element T6. In the fifteenth period P15, the light emitting element EE may emit a light according to the driving current.

The display panel 100 may be driven in a low frequency driving method. The display panel 100 may be driven in a variable frequency driving method. In an embodiment, for example, when the display panel 100 displays a moving image, the display panel 100 may be driven in a relatively high frequency. In such an embodiment, when the display panel 100 displays a static image, the display panel 100 may be driven in a relatively low frequency. In an embodiment, for example, when a possibility of flickering in the image displayed on the display panel 100 is high, the display panel 100 may be driven in a relatively high frequency. In such an embodiment, when the possibility of flickering in the image displayed on the display panel 100 is low, the display panel 100 may be driven in a relatively low frequency.

A driving frequency of the display panel 100 may include a writing period in which the data voltage VDATA is written to the pixel and the light emitting element EE emits a light and a holding period in which the data voltage VDATA is not written to the pixel and the light emitting element EE emits a light.

As described above, in the fourteenth period P14, the drain electrode N3 of the first switching element T1 may be initialized.

The voltage of the drain electrode of the first switching element T1 prior to the drain initialization in the writing period is ELVDD-VTH and the drain electrode of the first switching element T1 may be determined regardless of the data voltage VDATA. In contrast, the voltage of the drain electrode of the first switching element T1 prior to the drain initialization in the holding period is the light emitting voltage of the light emitting element EE and the drain electrode of the first switching element T1 may vary based on the data voltage VDATA.

The voltage of the drain electrode of the first switching element T1 after the drain initialization in the writing period is VINIT and the drain electrode of the first switching element T1 and the voltage of the drain electrode of the first switching element T1 after the drain initialization in the holding period is VINIT.

In the fourteenth period P14, the drain electrode N3 of the first switching element T1 is initialized such that the gate voltage, the source voltage and the drain voltage of the first switching element T1 in the writing period may be respectively the same as the gate voltage, the source voltage and the drain voltage of the first switching element T1 in the holding period. When the voltage condition of the first switching element T1 in the writing period is the same as the voltage condition of the first switching element T1 in the holding period, a luminance difference between in the writing period and in the holding period may be minimized in a variable frequency driving method such that the display quality of the display panel 100 may be enhanced.

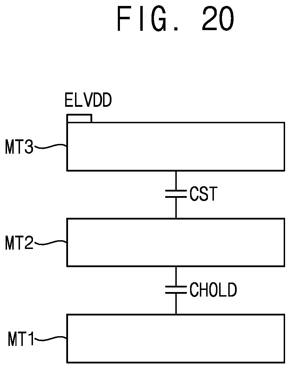

FIG. 20 is a diagram illustrating layer structures of a first capacitor CHOLD and a second capacitor CST of FIG. 2.

Referring to FIGS. 1 to 20, the first capacitor CHOLD may be formed between a first metal layer MT1 and a second metal layer MT2 disposed on the first metal layer MT1. The second capacitor CST may be formed between the second metal layer MT2 and a third metal layer MT3 disposed on the second metal layer MT2. The first capacitor CHOLD and the second capacitor CST may overlap with each other.

The pixel circuit may include two capacitors, but an area occupied by the capacitors may be minimized by stacking the capacitors in a serial capacitor manner.

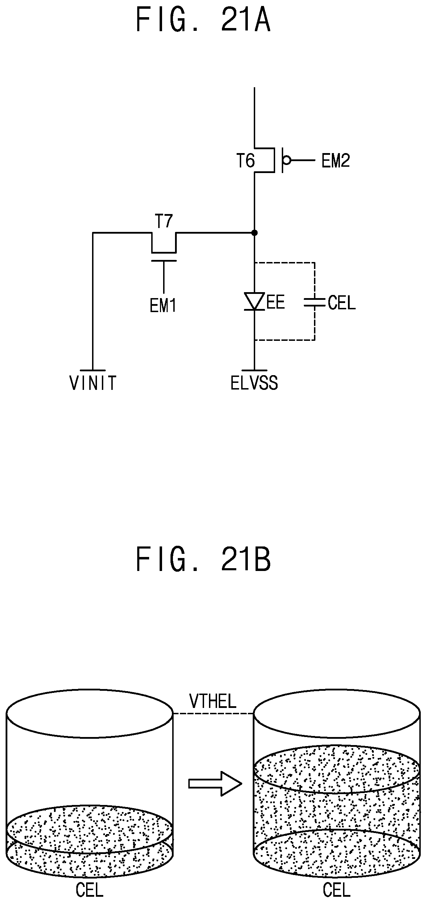

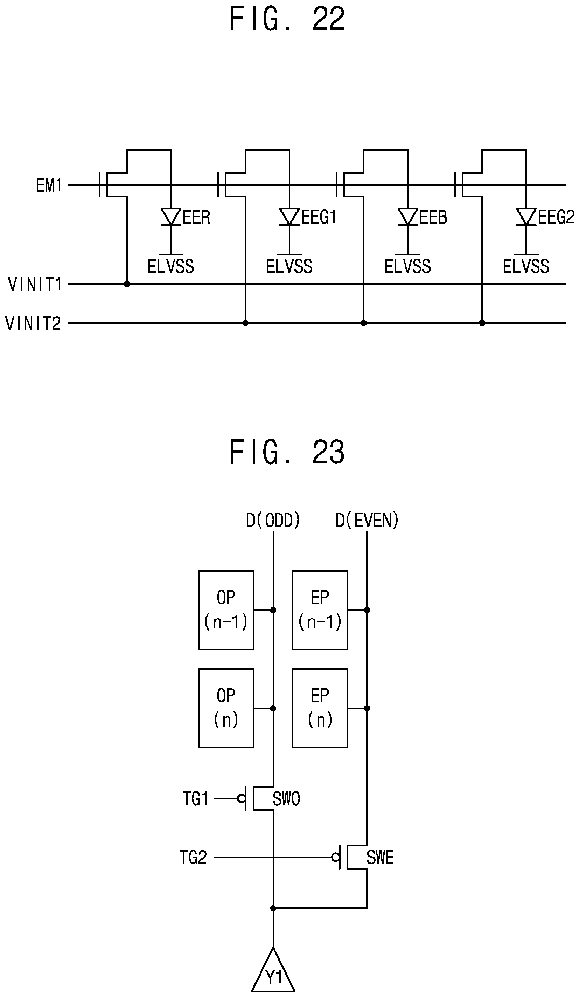

FIG. 21A is a circuit diagram illustrating a capacitance CEL of the light emitting element EE of FIG. 2. FIG. 21B is a diagram illustrating an initialization of an anode electrode of the light emitting element EE of FIG. 2. FIG. 22 is a diagram illustrating an initialization voltage VINIT1 and VINIT2 according to the pixel of the display panel 100 of FIG. 1.

Referring to FIGS. 1 to 22, in an embodiment, the initialization voltage VINIT may be used to initialize the anode electrode of the light emitting element EE and be used to initialize the voltage of the control electrode of the first switching element T1.

The initialization voltage VINIT for initializing the anode electrode of the light emitting element EE may be used to fill a capacitance CEL of the light emitting element EE such that a delay of the light emission may be reduced. The initialization voltage VINIT may be set to be greater than the second power voltage ELVSS by 1 volt (V) to 1.5 V

A left side diagram of FIG. 21B represents an initialization of an anode electrode of a light emitting element of a conventional pixel circuit. A right side diagram of FIG. 21B represents an initialization of the anode electrode of the light emitting element EE of the pixel circuit of an embodiment of the invention. Herein, VTHEL indicates a threshold voltage of the light emitting element EE.

In addition, a condition for the initialization voltage VINIT to initialize the control electrode of the first switching element T1 may satisfy the following Inequality 1.

[Inequality 1]

VINIT < Compensation Voltage Source – VTH(T1) – Margin of VINIT

Herein, assuming that a worst case value of VTH(T1) is 3.5 V, the margin of VINIT is 1.5 V, a black data voltage is 6.8 V, a white data voltage is 3.0 V and the first power voltage ELVDD is 4.6 V

In the conventional pixel circuit, the compensation voltage source is the data voltage. Thus, when the data voltage is the white data voltage of 3.0 V, VINIT < 3.0 V - 3.5 V - 1.5 V, that is, VINIT < -2.0 V

In contrast, in the pixel circuit of an embodiment of the invention, the compensation voltage source is not the data voltage but the first power voltage ELVDD. Thus, VINIT < 4.6 V - 3.5 V - 1.5 V, that is, VINIT < -0.4 V

As described above, the value of the initialization voltage VINIT may be set to be relatively high in the pixel circuit according to an embodiment of the invention such that the margin of the initialization voltage VINIT may be sufficient and the initialization voltage VINIT may be used both to initialize the anode electrode of the light emitting element EE and to initialize the voltage of the control electrode of the first switching element T 1.

In FIG. 22, a level of the initialization voltage may be varied based on a color of a pixel. For example, when the pixel is a red pixel (e.g. the pixel includes a red light emitting element EER), the initialization voltage may be a first initialization voltage VINIT1. For example, when the pixel is a blue pixel (e.g. the pixel includes a blue light emitting element EEB) or a green pixel (e.g. the pixel includes a green light emitting element EEG1 and EEG2), the initialization voltage may be a second initialization voltage VINIT2. Although a same initialization voltage VINIT2 is used for the blue pixel and the green pixel in an embodiment shown in FIG. 22, the invention may not be limited thereto. In another embodiment, for example, different initialization voltages may be used for the blue pixel and the green pixel.

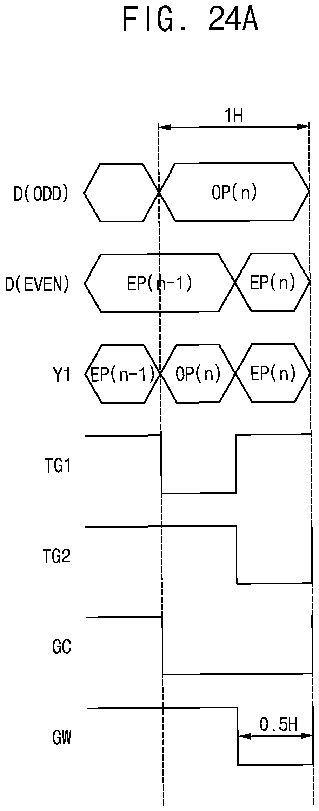

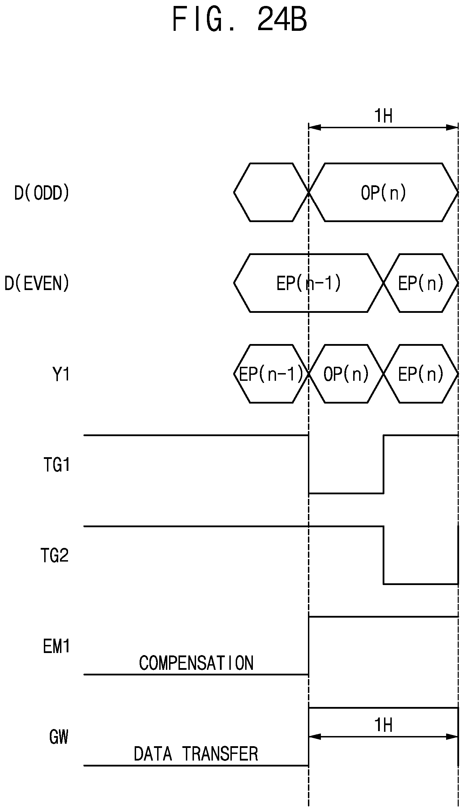

FIG. 23 is a circuit diagram illustrating a de-multiplexing structure of the data driver 500 of FIG. 1. FIG. 24A is a timing diagram illustrating input signals for operating a de-multiplexing structure of a data driver according to a comparative embodiment. FIG. 24B is a timing diagram illustrating input signals for operating the de-multiplexing structure of the data driver 500 of FIG. 23 according to an embodiment of the invention.

Referring to FIGS. 23 to 24B, in an embodiment, the data driver 500 may include an output buffer Y1.

The output buffer Y1 may be connected to an odd numbered data line D(ODD) and an even numbered data line D(EVEN). The odd numbered data line D(ODD) may be activated by an odd numbered switch SWO and the even numbered data line D(EVEN) may be activated by an even numbered switch SWE. The odd numbered switch SWO may be activated in response to a first selection signal TG1. The even numbered switch SWE may be activated in response to a second selection signal TG2.

The odd numbered data line D(ODD) may be connected to an odd numbered pixel OP(n-1) in an (n-1)-th pixel row and an odd numbered pixel OP(n) in an n-th pixel row. The even numbered data line D(EVEN) may be connected to an even numbered pixel EP(n-1) in the (n-1)-th pixel row and an even numbered pixel EP(n) in the n-th pixel row.

FIG. 24A represents input signals for operating a de-multiplexing structure in the conventional pixel circuit in which a compensation of a threshold voltage of the first switching element T1 and a data writing are simultaneously performed.

In the conventional pixel circuit, the data voltage is used as the compensation voltage source to compensate the threshold voltage of the first switching element T1. Thus, when a compensation gate signal is GC and a data writing gate signal is GW in FIG. 24A, the threshold voltage of the first switching element T1 may be compensated in a time duration when both of the compensation gate signal GC and the data writing gate signal GW have active levels. For example, in FIG. 24A, a time duration when the threshold voltage of the first switching element T1 is compensated may be 0.5H, which is a half of one horizontal period 1H. When a resolution of the display panel 100 increases and a driving frequency of the display panel 100 increases, the value (or time duration) of one horizontal period 1H decrease such that the time duration when the threshold voltage of the first switching element T1 is compensated may not be sufficient.

FIG. 24B represents input signals for operating the de-multiplexing structure in the pixel circuit of an embodiment of the invention in which a time for a compensation of a threshold voltage of the first switching element T1 and a time for a data writing are separated or set independently of each other.

In the pixel circuit according to an embodiment of the invention, the first power voltage ELVDD having a fixed value is used as the compensation voltage source such that the compensation of the threshold voltage of the first switching element T1 may be completed prior to the data writing. Thus, in such an embodiment, although the de-multiplexing structure is applied to the pixel circuit, the compensation time may not be reduced.

In the conventional pixel circuit, a time duration for the data writing may be 0.5H which is a half of one horizontal period 1H. In contrast, in the pixel circuit according to an embodiment of the invention, a time duration for the data writing may be one horizontal period 1H using an overlapping driving method. In the pixel circuit according to an embodiment, only the voltage change of the fourth node N4 is transferred to the first node N1 such that a significant data writing defect may not occur even if previous data is input during a period of 0.5H.

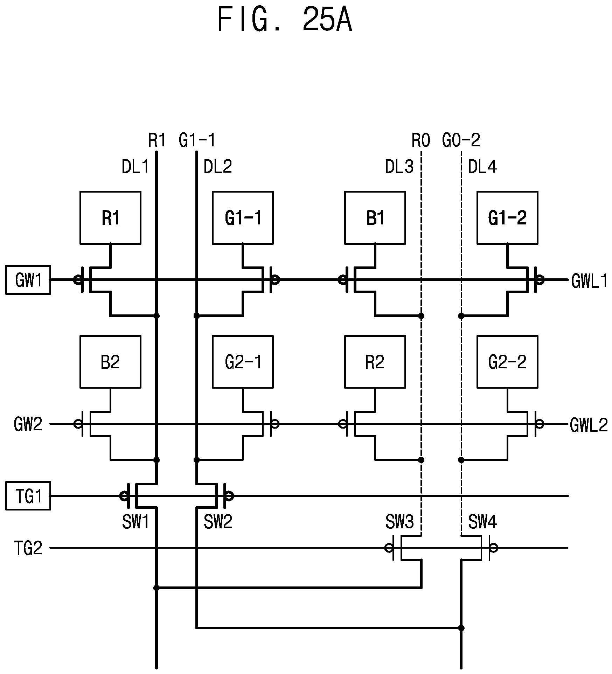

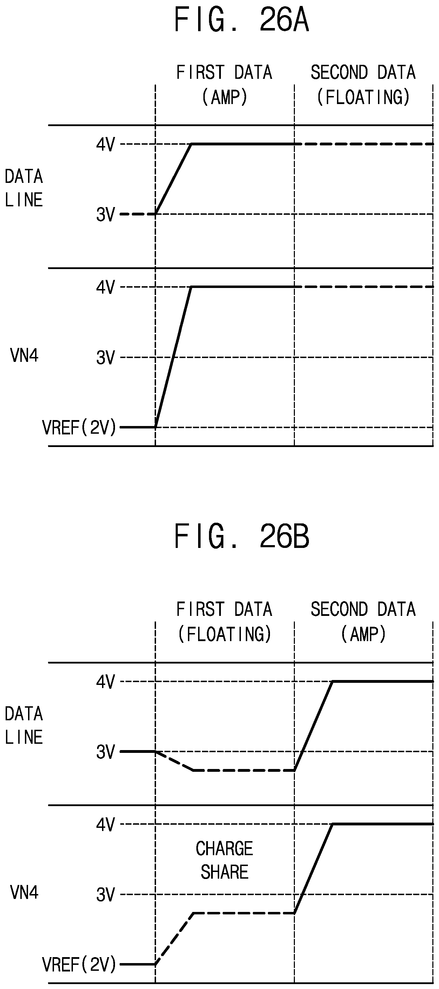

FIGS. 25A to 25D are diagrams illustrating a driving method of a flip structure of the pixel of the display panel 100 of FIG. 1 and the de-multiplexing structure of the data driver 500 of FIG. 1. FIG. 26A is a diagram illustrating a data voltage of a first pixel group and a voltage VN4 of the fourth node in FIGS. 25A to 25D. FIG. 26B is a diagram illustrating a data voltage of a second pixel group and the voltage VN4 of the fourth node N4 in FIGS. 25A to 25D.

Referring to FIGS. 1 to 26B, an embodiment of the display panel 100 may include a first pixel R1, a second pixel G1-1, a third pixel B1 and a fourth pixel G1-2, which are sequentially disposed in a first pixel row, and a fifth pixel B2, a sixth pixel G2-1, a seventh pixel R2 and an eighth pixel G2-2, which are sequentially disposed in a second pixel row. Each of the first to eighth pixels may include the pixel structure of FIG. 2.

In an embodiment, the display panel 100 may further include a first data writing gate line GWL1 connected to the first pixel R1, the second pixel G1-1, the third pixel B1 and the fourth pixel G1-2, a second data writing gate line GWL2 connected to the fifth pixel B2, the sixth pixel G2-1, the seventh pixel R2 and the eighth pixel G2-2, a first data line DL1 connected to the first pixel R1 and the fifth pixel B2, a second data line DL2 connected to the second pixel G1-1 and the sixth pixel G2-1, a third data line DL3 connected to the third pixel B1 and the seventh pixel R2 and a fourth data line DL4 connected to the fourth pixel G1-2 and the eighth pixel G2-2.

The first data line DL1 and the second data line DL2 may be disposed between the first pixel R1 and the second pixel G1-1. The third data line DL3 and the fourth data line DL4 may be disposed between the third pixel B1 and the fourth pixel G1-2.

The first pixel column, the second pixel column, the first data line DL1 and the second data line DL2 may have a symmetric structure. The above arranged structure of the pixels may be referred to as the flip structure.

The display panel 100 may further include a first switch SW1 that activates the first data line DL1 in response to the first selection signal TG1, a second switch SW2 that activates the second data line DL2 in response to the first selection signal TG1, a third switch SW3 that activates the third data line DL3 in response to the second selection signal TG2 and a fourth switch SW4 that activates the fourth data line DL4 in response to the second selection signal TG2.

The first data line DL1 and the third data line DL3 may be connected to each other. The second data line DL2 and the fourth data line DL4 may be connected to each other. The first data line DL1 and the third data line DL3 may be connected to a first output buffer of the data driver 500. The second data line DL2 and the fourth data line DL4 may be connected to a second output buffer of the data driver 500.

The first output buffer may output only red data and blue data. The second output buffer may output only green data. In an embodiment, for example, when a display image of the display panel 100 is a green single color image, an output of the first output buffer which outputs only the red data and the blue data maintains a zero grayscale value such that the first output buffer may not toggle and an output of the second output buffer which outputs only the green data maintains a 255 grayscale value such that the second output buffer may not toggle. For example, when a display image of the display panel 100 is a magenta single color image, an output of the first output buffer which outputs only the red data and the blue data maintains a 255 grayscale value such that the first output buffer may not toggle and an output of the second output buffer which outputs only the green data maintains a zero grayscale value such that the second output buffer may not toggle. According to an embodiment of FIGS. 25A to 25D, the power consumption may be reduced compared to a power consumption of a conventional structure in which a single output buffer alternately outputs red data, green data and blue data.

As shown in FIG. 25A, in a first timing, a first data writing gate signal GW 1 applied to the first data writing gate line GWL1 may have an active level and the first selection signal TG1 may have an active level.

In the first timing, the first data writing gate signal GW 1 may have the active level such that the first pixel R1 and the second pixel G1-1 may be turned on. In the first timing, the first selection signal TG1 may have the active level such that present data (AMP data shown in FIGS. 26A and 26B) may be applied to the first pixel R1 and the second pixel G1-1 from the first output buffer and the second output buffer through the first data line DL1 and the second data line DL2.

In the first timing, the first data writing gate signal GW1 may have the active level such that the third pixel B1 and the fourth pixel G1-2 may be turned on. However, in the first timing, the second selection signal TG2 may have an inactive level such that previous data (FLOATING data shown in FIGS. 26A and 26B) which have a floating state may be applied to the third pixel B1 and the fourth pixel G1-2.

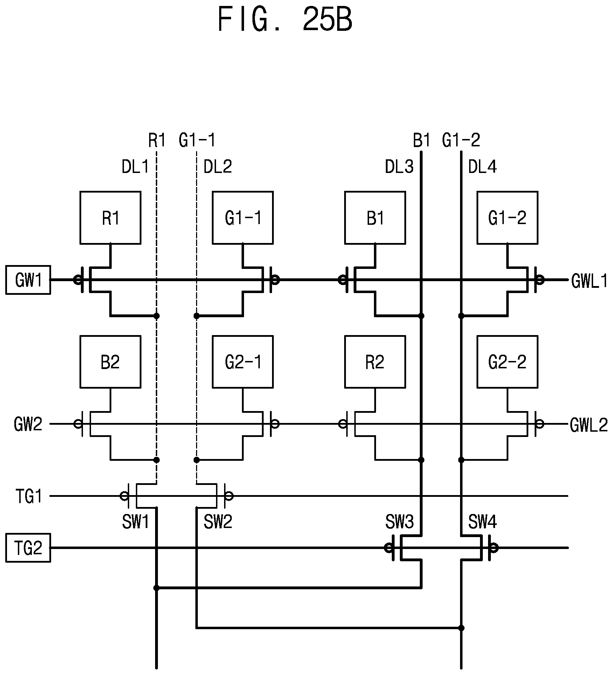

As shown in FIG. 25B, in a second timing, the first data writing gate signal GW 1 may have the active level and the second selection signal TG2 may have an active level.

In the second timing, the first data writing gate signal GW1 may have the active level such that the first pixel R1 and the second pixel G1-1 may be turned on. However, in the second timing, the first selection signal TG1 may have an inactive level such that present data (FLOATING data) which have a floating state may be applied to the first pixel R1 and the second pixel G1-1.

In the second timing, the first data writing gate signal GW1 may have the active level such that the third pixel B1 and the fourth pixel G1-2 may be turned on. In the second timing, the second selection signal TG2 may have an active level such that present data (AMP data) may be applied to the third pixel B1 and the fourth pixel G1-2 from the first output buffer and the second output buffer through the third data line DL3 and the fourth data line DL4.

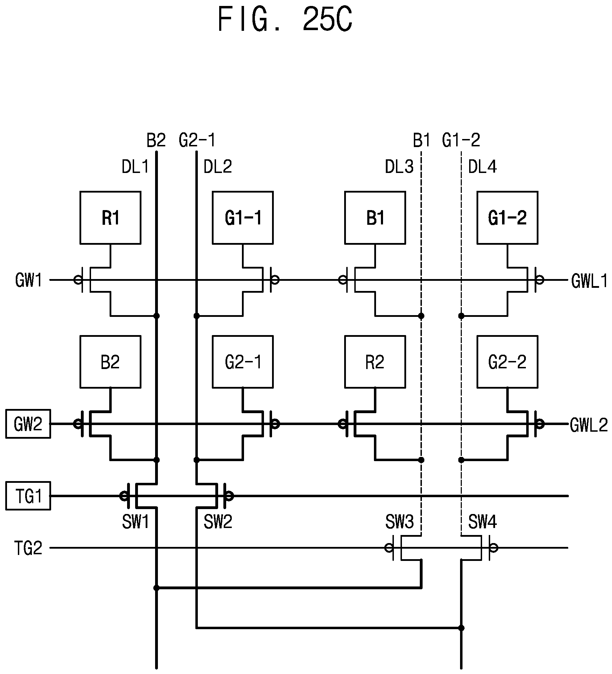

As shown in FIG. 25C, in a third timing, a second data writing gate signal GW2 applied to the second data writing gate line GWL2 may have an active level and the first selection signal TG1 may have the active level.

In the third timing, the second data writing gate signal GW2 may have the active level such that the fifth pixel B2 and the sixth pixel G2-1 may be turned on. In the third timing, the first selection signal TG1 may have the active level such that present data (AMP data) may be applied to the fifth pixel B2 and the sixth pixel G2-1 from the first output buffer and the second output buffer through the first data line DL1 and the second data line DL2.

In the third timing, the second data writing gate signal GW2 may have the active level such that the seventh pixel R2 and the eighth pixel G2-2 may be turned on. However, in the third timing, the second selection signal TG2 may have an inactive level such that previous data (FLOATING data) which have a floating state may be applied to the seventh pixel R2 and the eighth pixel G2-2.

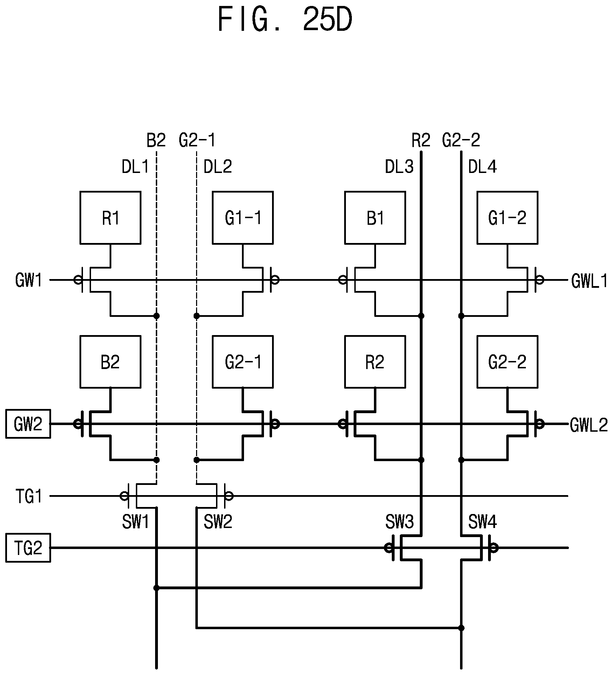

As shown in FIG. 25D, in a fourth timing, the second data writing gate signal GW2 may have the active level and the second selection signal TG2 may have the active level.

In the fourth timing, the second data writing gate signal GW2 may have the active level such that the fifth pixel B2 and the sixth pixel G2-1 may be turned on. However, in the fourth timing, the first selection signal TG1 may have an inactive level such that present data (FLOATING data) which have a floating state may be applied to the fifth pixel B2 and the sixth pixel G2-1.

In the fourth timing, the second data writing gate signal GW2 may have the active level such that the seventh pixel R2 and the eighth pixel G2-2 may be turned on. In the fourth timing, the second selection signal TG2 may have an active level such that present data (AMP data) may be applied to the seventh pixel R2 and the eighth pixel G2-2 from the first output buffer and the second output buffer through the third data line DL3 and the fourth data line DL4.

FIG. 26A represents the data voltage VDATA of the first pixel group R1, G1-1, B2 and G2-1 including first input data which is the present data (AMP data) and second input data which is the present data (FLOATING data) having the floating state and the voltage VN4 of the fourth node N4 of the first pixel group R1, G1-1, B2 and G2-1.

FIG. 26B represents the data voltage VDATA of the second pixel group B1, G1-2, R2 and G2-2 including first input data which is the previous data (FLOATING data) having the floating state and second input data which is the present data (AMP data) and the voltage VN4 of the fourth node N4 of the second pixel group B1, G1-2, R2 and G2-2.

When the AMP data are applied to the pixel, the level of the data voltage VDATA of the data line may be transmitted as it is to the fourth node N4. In contrast, when the FLOATING data having the floating state are applied to the pixel, the reference voltage VREF (e.g. 2V) and the data voltage VDATA of the data line may be charge-shared.

In the pixel circuit according to an embodiment of the invention, the compensation of the threshold voltage of the first switching element T1 is completed prior to the data writing, the data are transmitted by the coupling of the first capacitor CHOLD, the first pixel group and the second pixel group maintain the present data such that the flip structure of the pixel and the de-multiplexing structure of the data driver 500 are applicable.

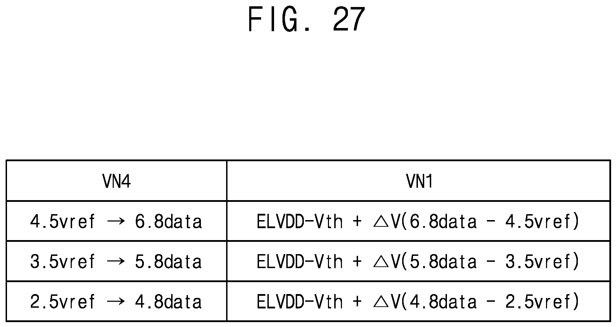

FIG. 27 is a table illustrating examples of voltages VN4 of the fourth node N4 and voltages VN1 of the first node N1 of the pixel circuit of FIG. 2.

Referring to FIGS. 1 to 27, in the pixel circuit according to an embodiment of the invention in which the data voltage VDATA is applied to the first switching element T1 using the coupling of the first capacitor CHOLD, a current equation of the light emitting element EE may be a following Equation 1.

[Equation 1]

$$IEE = \frac{1}{2} u Cox \frac{W}{L} (VREF - VDATA)^2$$

In Equation 1, IEE denotes the current flowing through the light emitting element EE, u such a mobility of the first switching element T1, Cox such a capacitance of the first switching element T1 and W/L such a ratio of a width and a length of a channel of the first switching element T1.

As shown in Equation 1, the current equation of the light emitting element EE may be determined by a difference between the reference voltage VREF and the data voltage VDATA. Thus, a luminance of the light emitting element EE may be maintained when levels of the reference voltage VREF and the data voltage VDATA are decreased together while maintaining the difference between the reference voltage VREF and the data voltage VDATA.

In the pixel circuit according to an embodiment, the levels of the reference voltage VREF and the data voltage VDATA may be set lower than those of a conventional pixel circuit such that the power consumption of the display apparatus may be reduced.

According to an embodiment, the data writing period PW and the compensation period PC of the pixel circuit are separated or set independently of each other such that the sufficient compensation time of the pixel circuit may be secured even when one horizontal period 1H is reduced.

According to an embodiment, the pixel circuit may include the relatively fewer transistors and the relatively fewer capacitors compared to those of the conventional pixel circuit, such that the integration may be enhanced and the pixel circuit may be applicable to a high resolution display apparatus.

According to an embodiment of the pixel circuit, the number of integrated circuits which generate the gate signal and the emission signal in the display apparatus is small, such that the dead space may be reduced.

According to an embodiment of the pixel circuit, the flip structure of the pixel and the de-multiplexing structure of the data driver 500 may be applicable in the display apparatus such that the power consumption may be reduced and the integration may be enhanced.

According to an embodiment of the pixel circuit, the pixel circuit may be driven in a relatively low reference voltage VREF and a relatively low data voltage VDATA compared to those of the conventional pixel circuit such that the power consumption may be reduced.

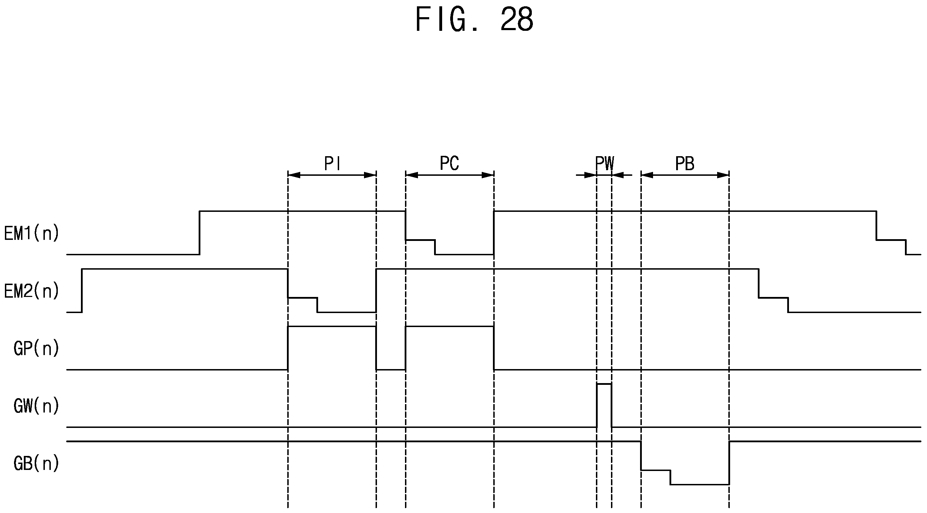

FIG. 28 is a timing diagram illustrating input signals applied to a pixel circuit of a display panel of a display apparatus according to an embodiment of the invention.

The display apparatus according to an embodiment shown in FIG. 28 is substantially the same as the display apparatus according to the embodiments described above referring to FIGS. 1 to 27 except for the waveform of the path activation gate signal applied to the pixel circuit. Thus, the same reference numerals will be used to refer to the same or like parts as those described above with reference to FIGS. 1 to 27 and any repetitive detailed description thereof will be omitted or simplified.

Referring to FIGS. 1, 2 and 5 to 28, an embodiment of the pixel circuit includes a light emitting element EE, a first switching element T1, a first capacitor CHOLD, a second switching element T2, a third switching element T3 and a fourth switching element T4.

The first switching element T1 may include a control electrode connected to a first node N1, a first electrode connected to a second node N2 and a second electrode connected to a third node N3. The first switching element T1 may apply a driving current to the light emitting element EE. The first capacitor CHOLD may include a first electrode connected to a fourth node N4 and a second electrode connected to the first node N1. The second switching element T2 may apply a data voltage VDATA to the fourth node N4 in response to the data writing gate signal GW. The third switching element T3 may connect the first node N1 and the third node N3 to each other in response to the path activation gate signal GP. The fourth switching element T4 may apply a reference voltage VREF to the fourth node N4 in response to the path activation gate signal GP.

The pixel circuit may further include a fifth switching element T5 and a sixth switching element T6. The fifth switching element T5 may apply a first power voltage ELVDD to the second node N2 in response to a first emission signal EM1. The sixth switching element T6 may connect the third node N3 and an anode electrode of the light emitting element EE to each other in response to a second emission signal EM2. The pixel circuit may further include a seventh switching element T7. The seventh switching element T7 may apply an initialization voltage VINIT to the anode electrode of the light emitting element EE in response to the first emission signal EM1. The pixel circuit may further include an eighth switching element T8. The eighth switching element T8 may apply a bias voltage VBIAS to the second node N2 in response to the bias gate signal GB.

For example, the first switching element T1 may be the P-type transistor. The second switching element T2 may be the N-type transistor. The third switching element T3 may be the N-type transistor. The fourth switching element T4 may be the N-type transistor.

For example, the fifth switching element T5 may be the P-type transistor. The sixth switching element T6 may be the P-type transistor. The seventh switching element T7 may be the N-type transistor. The eighth switching element T8 may be the P-type transistor.

A driving timing of the pixel circuit may include an initialization period PI, a compensation period PC, a data writing period PW and a bias period PB.

For example, in the initialization period PI, the first emission signal EM1 may have an inactive level, the second emission signal EM2 may have an active level, the path activation gate signal GP may have an active level, the data writing gate signal GW may have an inactive level and the bias gate signal GB may have an inactive level.

For example, in the compensation period PC, the first emission signal EM1 may have an active level, the second emission signal EM2 may have an inactive level, the path activation gate signal GP may have the active level, the data writing gate signal GW may have the inactive level and the bias gate signal GB may have the inactive level.

For example, in the data writing period PW, the first emission signal EM1 may have the inactive level, the second emission signal EM2 may have the inactive level, the path activation gate signal GP may have an inactive level, the data writing gate signal GW may have an active level and the bias gate signal GB may have the inactive level.

For example, in the bias period PB, the first emission signal EM1 may have the inactive level, the second emission signal EM2 may have the inactive level, the path activation gate signal GP may have the inactive level, the data writing gate signal GW may have the inactive level and the bias gate signal GB may have an active level.

In an embodiment, the path activation gate signal GP may have the active level in the initialization period PI and the compensation period PC. The path activation gate signal GP may have an inactive level between the initialization period PI and the compensation period PC.

According to an embodiment, the data writing period PW and the compensation period PC of the pixel circuit are separated or set independently of each other such that the sufficient compensation time of the pixel circuit may be secured.

The pixel circuit may include the relatively fewer transistors and the relatively fewer capacitors compared to those of the conventional pixel circuit, such that the integration may be enhanced and the pixel circuit may be applicable to a high resolution display apparatus.

According to an embodiment of the pixel circuit, the number of integrated circuits which generate the gate signal and the emission signal in the display apparatus is small, such that the dead space may be reduced.

According to an embodiment of the pixel circuit, the flip structure of the pixel and the de-multiplexing structure of the data driver 500 may be applicable in the display apparatus such that the power consumption may be reduced and the integration may be enhanced.

According to an embodiment of the pixel circuit, the pixel circuit may be driven in a relatively low reference voltage VREF and a relatively low data voltage VDATA compared to those of the conventional pixel circuit such that the power consumption may be reduced.

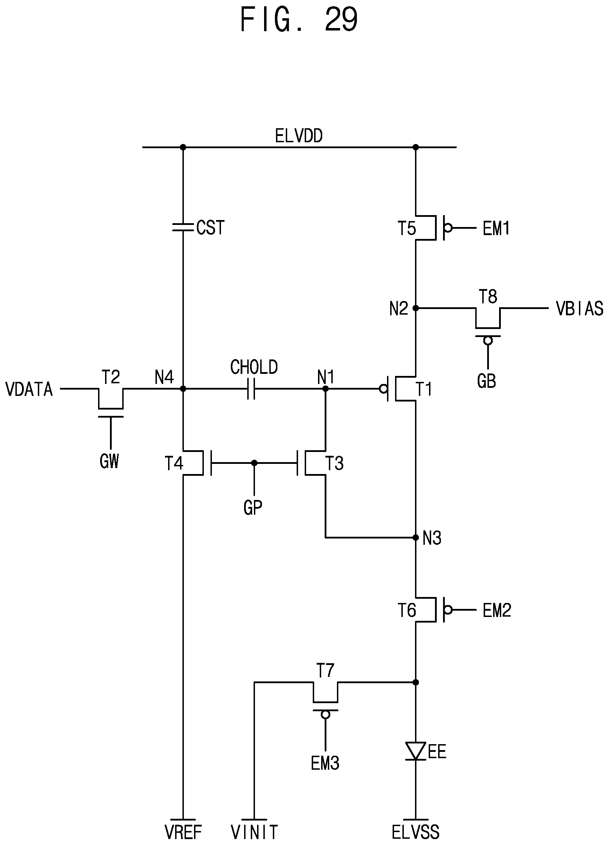

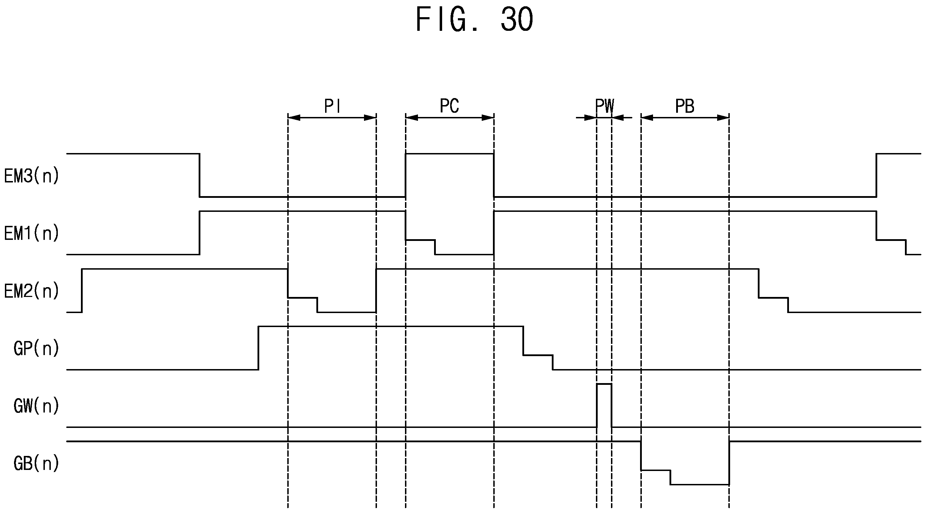

FIG. 29 is a circuit diagram illustrating a pixel circuit of a display panel 100 of a display apparatus according to an embodiment of the invention. FIG. 30 is a timing diagram illustrating input signals applied to the pixel circuit of FIG. 29.

The display apparatus according to an embodiment shown in FIGS. 29 and 30 is substantially the same as the display apparatus according to the embodiments described above referring to FIGS. 1 to 27 except that the seventh switching element is a P-type transistor. Thus, the same reference numerals will be used to refer to the same or like parts as those described in the previous embodiment of FIGS. 1 to 27 and any repetitive detailed description thereof will be omitted or simplified.

Referring to FIGS. 1, 5 to 27, 29 and 30, an embodiment of the pixel circuit includes a light emitting element EE, a first switching element T1, a first capacitor CHOLD, a second switching element T2, a third switching element T3 and a fourth switching element T4.

The first switching element T1 may include a control electrode connected to a first node N1, a first electrode connected to a second node N2 and a second electrode connected to a third node N3. The first switching element T1 may apply a driving current to the light emitting element EE. The first capacitor CHOLD may include a first electrode connected to a fourth node N4 and a second electrode connected to the first node N1. The second switching element T2 may apply a data voltage VDATA to the fourth node N4 in response to the data writing gate signal GW. The third switching element T3 may connect the first node N1 and the third node N3 to each other in response to the path activation gate signal GP. The fourth switching element T4 may apply a reference voltage VREF to the fourth node N4 in response to the path activation gate signal GP.

The pixel circuit may further include a fifth switching element T5 and a sixth switching element T6. The fifth switching element T5 may apply a first power voltage ELVDD to the second node N2 in response to a first emission signal EM1. The sixth switching element T6 may connect the third node N3 and an anode electrode of the light emitting element EE to each other in response to a second emission signal EM2.

The pixel circuit may further include a seventh switching element T7. The seventh switching element T7 may apply an initialization voltage VINIT to the anode electrode of the light emitting element EE in response to a third emission signal EM3.

The pixel circuit may further include an eighth switching element T8. The eighth switching element T8 may apply a bias voltage VBIAS to the second node N2 in response to the bias gate signal GB.

For example, the first switching element T1 may be the P-type transistor. The second switching element T2 may be the N-type transistor. The third switching element T3 may be the N-type transistor. The fourth switching element T4 may be the N-type transistor.

For example, the fifth switching element T5 may be the P-type transistor. The sixth switching element T6 may be the P-type transistor. The eighth switching element T8 may be the P-type transistor.

In the embodiment, the seventh switching element T7 may be the P-type transistor.

A driving timing of the pixel circuit may include an initialization period PI, a compensation period PC, a data writing period PW and a bias period PB.

In an embodiment, the third emission signal EM3 may have a waveform substantially opposite to the waveform of the first emission signal EM1.

For example, in the initialization period PI, the first emission signal EM1 may have an inactive level, the second emission signal EM2 may have an active level, the third emission signal EM3 may have an active level, the path activation gate signal GP may have an active level, the data writing gate signal GW may have an inactive level and the bias gate signal GB may have an inactive level.

For example, in the compensation period PC, the first emission signal EM1 may have an active level, the second emission signal EM2 may have an inactive level, the third emission signal EM3 may have an inactive level, the path activation gate signal GP may have the active level, the data writing gate signal GW may have the inactive level and the bias gate signal GB may have the inactive level.

For example, in the data writing period PW, the first emission signal EM1 may have the inactive level, the second emission signal EM2 may have the inactive level, the third emission signal EM3 may have the active level, the path activation gate signal GP may have an inactive level, the data writing gate signal GW may have an active level and the bias gate signal GB may have the inactive level.

For example, in the bias period PB, the first emission signal EM1 may have the inactive level, the second emission signal EM2 may have the inactive level, the third emission signal EM3 may have the active level, the path activation gate signal GP may have the inactive level, the data writing gate signal GW may have the inactive level and the bias gate signal GB may have an active level.

According to an embodiment, the data writing period PW and the compensation period PC of the pixel circuit are separated or set independently of each other such that the sufficient compensation time of the pixel circuit may be secured.

In such an embodiment, the pixel circuit may include the relatively fewer transistors and the relatively fewer capacitors compared to those of the conventional pixel circuit, such that the integration may be enhanced and the pixel circuit may be applicable to a high resolution display apparatus.

According to an embodiment of the pixel circuit, the number of integrated circuits which generate the gate signal and the emission signal in the display apparatus is small, such that the dead space may be reduced.

According to an embodiment of the pixel circuit, the flip structure of the pixel and the de-multiplexing structure of the data driver 500 may be applicable in the display apparatus such that the power consumption may be reduced and the integration may be enhanced.

According to the pixel circuit, the pixel circuit may be driven in a relatively low reference voltage VREF and a relatively low data voltage VDATA compared to those of the conventional pixel circuit such that the power consumption may be reduced.

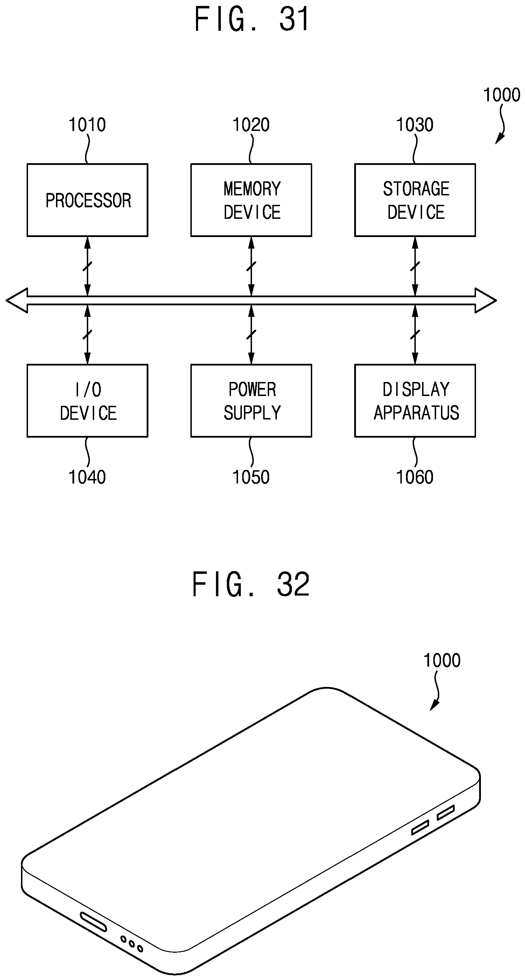

FIG. 31 is a block diagram illustrating an electronic apparatus according to an embodiment of the invention. FIG. 32 is a diagram illustrating an example in which the electronic apparatus of FIG. 31 is implemented as a smart phone.

Referring to FIGS. 31 and 32, n embodiment of the electronic apparatus 1000 may include a processor 1010, a memory device 1020, a storage device 1030, an input/output (I/O) device 1040, a power supply 1050, and a display apparatus 1060. Here, the display apparatus 1060 may be the display apparatus of FIG. 1. In addition, the electronic apparatus 1000 may further include a plurality of ports for communicating with a video card, a sound card, a memory card, a universal serial bus (USB) device, other electronic apparatuses, etc.

In an embodiment, as illustrated in FIG. 32, the electronic apparatus 1000 may be implemented as a smart phone. However, the electronic apparatus 1000 is not limited thereto. For example, the electronic apparatus 1000 may be implemented as a cellular phone, a video phone, a smart pad, a smart watch, a tablet computer, a car navigation system, a computer monitor, a laptop, a head mounted display (HMD) device, or the like.

The processor 1010 may perform various computing functions or various tasks. The processor 1010 may be a micro-processor, a central processing unit (CPU), an application processor (AP), or the like. The processor 1010 may be coupled to other components via an address bus, a control bus, a data bus, etc. Further, the processor 1010 may be coupled to an extended bus such as a peripheral component interconnection (PCI) bus.

The processor 1010 may output the input image data IMG and the input control signal CONT to the driving controller 200 of FIG. 1.

The memory device 1020 may store data for operations of the electronic apparatus 1000. For example, the memory device 1020 may include at least one non-volatile memory device such as an erasable programmable read-only memory (EPROM) device, an electrically erasable programmable read-only memory (EEPROM) device, a flash memory device, a phase change random access memory (PRAM) device, a resistance random access memory (RRAM) device, a nano floating gate memory (NFGM) device, a polymer random access memory (PoRAM) device, a magnetic random access memory (MRAM) device, a ferroelectric random access memory (FRAM) device, or the like and/or at least one volatile memory device such as a dynamic random access memory (DRAM) device, a static random access memory (SRAM) device, a mobile DRAM device, or the like.

The storage device 1030 may include a solid state drive (SSD) device, a hard disk drive (HDD) device, a CD-ROM device, or the like. The I/O device 1040 may include an input device such as a keyboard, a keypad, a mouse device, a touch-pad, a touch-screen, and or like and an output device such as a printer, a speaker, or the like. In some embodiments, the display apparatus 1060 may be included in the I/O device 1040. The power supply 1050 may provide power for operations of the electronic apparatus 1000. The display apparatus 1060 may be coupled to other components via the buses or other communication links.

According to embodiments of the pixel circuit, the display panel and the display apparatus, as described above, the pixel circuit may have sufficient compensation time such that the display apparatus may supply the high frequency driving method and the pixel circuit includes fewer transistors such that the display apparatus may be applicable to a high resolution display apparatus.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the spirit or scope of the invention as defined by the following claims.

**Claims**

1. A pixel circuit comprising:

   a light emitting element (EE);
   a first switching element (T1) including a control electrode connected to a first node (N1), a first electrode connected to a second node (N2) and a second electrode connected to a third node (N3), wherein the first switching element (T1) applies a driving current to the light emitting element (EE);
   a first capacitor (CHOLD) including a first electrode connected to a fourth node (N4) and a second electrode connected to the first node (N1);
   a second switching element (T2) which applies a data voltage (VDATA) to the fourth node (N4) in response to a data writing gate signal (GW);
   a third switching element (T3) which connects the first node (N1) and the third node (N3) to each other in response to a path activation gate signal (GP); and
   a fourth switching element (T4) which applies a reference voltage (VREF) to the fourth node (N4) in response to the path activation gate signal (GP).

2. The pixel circuit of claim 1, wherein the first switching element (T1) is a P-type transistor,

   wherein the second switching element (T2) is an N-type transistor,
   wherein the third switching element (T3) is an N-type transistor, and
   wherein the fourth switching element (T4) is an N-type transistor.

3. The pixel circuit of claim 1, further comprising:

   a fifth switching element (T5) which applies a first power voltage (ELVDD) to the second node (N2) in response to a first emission signal (EM1); and
   a sixth switching element (T6) which connects the third node (N3) and an anode electrode of the light emitting element (EE) to each other in response to a second emission signal (EM2).

4. The pixel circuit of claim 3, further comprising:
   a seventh switching element (T7) which applies an initialization voltage (VINIT) to the anode electrode of the light emitting element (EE) in response to the first emission signal (EM1).

5. The pixel circuit of claim 4, wherein the fifth switching element (T5) is a P-type transistor, and
   wherein the seventh switching element (T7) is an N-type transistor.

6. The pixel circuit of claim 5, wherein the sixth switching element (T6) is a P-type transistor.

7. The pixel circuit of claim 3, further comprising:
   a seventh switching element (T7) which applies an initialization voltage (VINIT) to the anode electrode of the light emitting element (EE) in response to a third emission signal.

8. The pixel circuit of claim 7, wherein the fifth switching element (T5) is a P-type transistor, and
   wherein the seventh switching element (T7) is a P-type transistor.

9. The pixel circuit of claim 1, further comprising:
   an eighth switching (T8) element which applies a bias voltage (VBIAS) to the second node (N2) in response to a bias gate signal.

10. The pixel circuit of claim 1, further comprising:
    a second capacitor (CST) including a first electrode which receives a first power voltage (ELVDD) and a second electrode connected to the fourth node (N4).

11. The pixel circuit of claims 1 to 10, wherein the second switching element (T2) includes a control electrode which receives the data writing gate signal (GW), a first electrode which receives the data voltage (VDATA) and a second electrode connected to the fourth node (N4),

wherein the third switching element (T3) includes a control electrode which receives the path activation gate signal (GP), a first electrode connected to the first node (N1) and a second electrode connected to the third node (N3), and

wherein the fourth switching element (T4) includes a control electrode which receives the path activation gate signal (GP), a first electrode connected to the fourth node (N4) and a second electrode which receives the reference voltage.

12. The pixel circuit of claims 1 to 11, further comprising:

a fifth switching element (T5) which applies a first power voltage (ELVDD) to the second node (N2) in response to a first emission signal (EM1); and

a sixth switching element (T6) which connects the third node (N3) and an anode electrode of the light emitting element (EE) to each other in response to a second emission signal (EM2),

wherein the first emission signal (EM1) and the second emission signal (EM2) are generated from a same signal generator.

13. The pixel circuit of claims 1 to 11, further comprising:

a fifth switching element (T5) which applies a first power voltage (ELVDD) to the second node (N2) in response to a first emission signal (EM1); and

a sixth switching element (T6) which connects the third node (N3) and an anode electrode of the light emitting element (EE) to each other in response to a second emission signal (EM2),

wherein in an initialization period (PI), the first emission signal (EM1) has an inactive level, the second emission signal (EM2) has an active level and the path activation gate signal (GP) has an active level, and

wherein in a compensation period (PC) subsequent to the initialization period (PI), the first emission signal (EM1) has an active level, the second emission signal (EM2) has an inactive level and the path activation gate signal (GP) has the active level.

14. A display panel (100) comprising:

a first pixel (R1), a second pixel (G1-1), a third pixel (B1) and a fourth (G1-2) pixel, which are sequentially disposed in a first pixel row; and

a fifth pixel (B2), a sixth pixel (G2-1), a seventh pixel (R2) and an eighth pixel (G2-2), which are sequentially disposed in a second pixel row,

wherein at least one selected from the first to eighth pixels (R1, G1-1, B1, G1-2, B2, G2-1, R2, G2-2) comprises:

a light emitting element (EE);

a first switching element (T1) including a control electrode connected to a first node (N1), a first electrode connected to a second node (N2) and a second electrode connected to a third node (N3), wherein the first switching element (T1) applies a driving current to the light emitting element (EE);

a first capacitor (CHOLD) including a first electrode connected to a fourth node (N4) and a second electrode connected to the first node (N1);

a second switching element (T2) which applies a data voltage (VDATA) to the fourth node (N4) in response to a data writing gate signal (GW);

a third switching element (T3) which connects the first node (N1) and the third node (N3) to each other in response to a path activation gate signal (GP); and

a fourth switching element (T4) which applies a reference voltage (VREF) to the fourth node (N4) in response to the path activation gate signal (GP).

15. A display apparatus (1060) comprising:

a display panel (100) including a pixel circuit;

a gate driver (300) which applies a gate signal (GW) to the pixel circuit; and
a data driver (500) which applies a data voltage (VDATA) to the pixel circuit,
wherein the pixel circuit comprises:

a light emitting element (EE);
a first switching element (T1) including a control electrode connected to a first node (N1), a first electrode connected to a second node (N2) and a second electrode connected to a third node (N3), wherein the first switching element (T1) applies a driving current to the light emitting element (EE);
a first capacitor (CHOLD) including a first electrode connected to a fourth node (N4) and a second electrode connected to the first node (N1);
a second switching element (T2) which applies the data voltage (VDATA) to the fourth node (N4) in response to a data writing gate signal (GW);
a third switching element (T3) which connects the first node (N1) and the third node (N3) to each other in response to a path activation gate signal (GP); and
a fourth switching element (T4) which applies a reference voltage (VREF) to the fourth node (N4) in response to the path activation gate signal (GP).

# FIG. 1

# FIG. 2

FIG. 3

# FIG. 4

EP 4 576 058 A1

# FIG. 5

# FIG. 6

# FIG. 7

# FIG. 8

# FIG. 9

# FIG. 10

# FIG. 11

# FIG. 12

# FIG. 13

# FIG. 14

# FIG. 15

# FIG. 16

# FIG. 17

# FIG. 18

# FIG. 19

# FIG. 20

# FIG. 21A

# FIG. 21B

# FIG. 22

EM1

EER ELVSS  EEG1 ELVSS  EEB ELVSS  EEG2 ELVSS

VINIT1

VINIT2

# FIG. 23

D(ODD)  D(EVEN)

OP (n-1)  EP (n-1)

OP (n)  EP (n)

TG1  SWO

TG2  SWE

Y1

# FIG. 24A

# FIG. 24B

1H

D(ODD)        OP(n)

D(EVEN)    EP(n-1)    EP(n)

Y1    EP(n-1)  OP(n)  EP(n)

TG1

TG2

EM1
COMPENSATION

GW              1H
DATA TRANSFER

# FIG. 25A

# FIG. 25B

# FIG. 25C

# FIG. 25D

# FIG. 26A

FIRST DATA (AMP) · SECOND DATA (FLOATING)

DATA LINE

VN4

# FIG. 26B

FIRST DATA (FLOATING) · SECOND DATA (AMP)

DATA LINE

VN4

CHARGE SHARE

# FIG. 27

| VN4 | VN1 |
|---|---|
| 4.5vref → 6.8data | ELVDD-Vth + △V(6.8data − 4.5vref) |
| 3.5vref → 5.8data | ELVDD-Vth + △V(5.8data − 3.5vref) |
| 2.5vref → 4.8data | ELVDD-Vth + △V(4.8data − 2.5vref) |

# FIG. 28

EP 4 576 058 A1

# FIG. 29

# FIG. 30

EP 4 576 058 A1

# FIG. 31

# FIG. 32

Europäisches
Patentamt

European
Patent Office

Office européen
des brevets

# EUROPEAN SEARCH REPORT

**Application Number**

EP 24 22 2201

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/284850 A1 (PARK JUNHYUN [KR] ET AL) 8 September 2022 (2022-09-08) * paragraph [0052] - paragraph [0121]; figures 1, 15 * | 1-15 | INV. G09G3/3233 |
| A | US 2023/108865 A1 (KIM JAY BUM [KR] ET AL) 6 April 2023 (2023-04-06) * paragraph [0099] - paragraph [0123]; figure 2 * | 1-15 | |
| A | US 2014/118409 A1 (JUN BYUNG-GEUN [KR] ET AL) 1 May 2014 (2014-05-01) * paragraph [0066] - paragraph [0068]; figure 2 * | 14 | |

**TECHNICAL FIELDS SEARCHED (IPC)**

G09G

The present search report has been drawn up for all claims

| Place of search | Date of completion of the search | Examiner |
|---|---|---|
| Munich | 20 March 2025 | Mayerhofer, Alevtina |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

# EP 4 576 058 A1

## ANNEX TO THE EUROPEAN SEARCH REPORT
## ON EUROPEAN PATENT APPLICATION NO.

EP 24 22 2201

20-03-2025

| Patent document cited in search report | Publication date | Patent family member(s) | Publication date |
|---|---|---|---|
| US 2022284850 A1 | 08-09-2022 | CN 115035831 A | 09-09-2022 |
| | | KR 20220125871 A | 15-09-2022 |
| | | US 2022284850 A1 | 08-09-2022 |
| US 2023108865 A1 | 06-04-2023 | CN 115881015 A | 31-03-2023 |
| | | CN 220189225 U | 15-12-2023 |
| | | KR 20230047282 A | 07-04-2023 |
| | | US 11610541 B1 | 21-03-2023 |
| US 2014118409 A1 | 01-05-2014 | KR 20140053606 A | 08-05-2014 |
| | | US 2014118409 A1 | 01-05-2014 |

EPO FORM P0459

For more details about this annex : see Official Journal of the European Patent Office, No. 12/82